Europäisches Patentamt

European Patent Office

Office européen des brevets

(19)

(11) Publication number: **0 172 734 B1**

(12) **EUROPEAN PATENT SPECIFICATION**

(45) Date of publication of patent specification: **25.03.92** (51) Int. Cl.5: **G06F 11/10, G06F 11/20**

(21) Application number: **85305828.7**

(22) Date of filing: **16.08.85**

(54) Semiconductor memory device.

(30) Priority: **17.08.84 JP 171317/84**

(43) Date of publication of application:
**26.02.86 Bulletin 86/09**

(45) Publication of the grant of the patent:
**25.03.92 Bulletin 92/13**

(84) Designated Contracting States:
**DE FR GB**

(56) References cited:
**EP-A- 0 032 957**
**EP-A- 0 077 204**
**FR-A- 2 501 891**

**IEEE JOURNAL OF SOLID-STATE CIRCUITS,
vol. SC-18, no. 5, October 1983, pages
463-469, IEEE, New York, US; T. MANO et al.:
"Circuit techniques for a VLSI memory"**

(73) Proprietor: **FUJITSU LIMITED
1015, Kamikodanaka Nakahara-ku
Kawasaki-shi Kanagawa 211(JP)**

(72) Inventor: **Takemae, Yoshihiro
8-13-24-303, Akasaka Minato-ku
Tokyo 107(JP)**

(74) Representative: **Sunderland, James Harry et al
HASELTINE LAKE & CO Hazlitt House 28
Southampton Buildings Chancery Lane
London WC2A 1AT(GB)**

## Description

The present invention relates to a semiconductor memory device having an error correction function.

A redundant (redundancy) technique is widely known which improves the yield of semiconductor memory devices. In the redundant technique, a redundant memory cell array storing correct data is added to a regular memory cell array, and when a defective memory cell is selected to be read, a redundant memory cell is actually read in place of the defective memory cell, so that the correct data can be read. However, this redundant technique can be applied only to previously determined defective memory cells. That is, once defective memory cells are determined, other defective read data caused by hard errors or soft errors after the determination of the defective memory cells can not be corrected.

An increase in the capacity of a dynamic-type memory device causes increased occurrence of soft errors due to $\alpha$ rays. Whether the data read from the memory is correct or incorrect can be determined by means of parity checking. However, although the presence of an error bit may be determined by the parity checking, the position (address) of the error bit cannot be determined, and accordingly, error correction cannot be performed. To determine the error bit and to make it correctable, an improved parity checking technique employing a parity-checking two-dimensional virtual matrix has conventionally been incorporated into a conventional semiconductor memory device (see, for example, Patent Publication FR-A- 2 502 377, Inventor: Junzo Yamada et al., applicant:- NTT. This conventional semiconductor memory device employing a parity-checking two-dimensional virtual matrix, however, can correct only a single bit error, as later described in more detail, and since the redundant technique is not employed, it provides a low yield.

It is desirable for the redundant technique to be combined with the improved parity checking technique so as to be able not only to correct the previously determined hard errors but also to correct soft errors or hard errors caused after the determination of the previously determined hard errors. However, since the parity-checking two-dimensional virtual matrix has a predetermined logic for outputting data in response to a selected memory cell, it is impossible to simply replace a defective column with the redundant column. Therefore, unless a great number of circuit elements for preventing the previously determined defective hard errors from entering the two-dimensional virtual matrix are used, it is difficult to combine the redundant technique with the improved parity checking technique.

According to the present invention, there is provided a semiconductor memory device comprising:-

a memory cell array including a plurality of memory cells arranged in a matrix;

an error correcting circuit including:-

a data selector, operatively connected to said memory cell array, for receiving read data from a plurality of memory cells including a selected memory cell, and for selectively outputting a part of said read data which forms horizontal and vertical parity checking groups corresponding to a parity-checking two-dimensional virtual matrix;

a vertical parity generator and a horizontal parity generator, operatively connected to the data selector, for generating a vertical and horizontal parity of said data group, respectively;

a parity storing memory for storing a previously determined vertical and horizontal parity;

a comparator, operatively connected to said vertical and horizontal parity generators and to said parity storing memory, for comparing the outputs thereof to detect an error in said read data;

a data correcting gate for correcting said error in said read data in response to an output of said comparator; and

a data bus for transferring read data from said data selector to said data correcting gate; characterised by:-

a redundant memory cell for replacing a defective memory cell of said memory cell array;

a switching circuit for switching between the output of the redundant memory cell and the data bus, connected between the data bus and an input of the data correcting gate; and

an inhibit and parity generating circuit, comprising:-

an inhibit circuit, operatively connected between said data selector and said vertical and horizontal parity generators;

a redundant-cell parity generating circuit, operatively connected to said redundant memory cell and to said vertical and horizontal parity generators; and

an inhibit control circuit, operatively receiving an external address signal for selecting a memory cell in said memory cell array, and operatively connected to said switching circuit, to said inhibit circuit and to said redundant-cell parity generating circuit;

said inhibit control circuit being operable to generate, in response to an external address which specifies a defective memory cell, a redundant switching signal to be applied to said switching circuit, inhibit signals to be applied to said inhibit circuit, and a control signal to be applied to said redundant-cell parity generating circuit; whereby:-

said switching circuit selects the correct data from the redundant memory cell;

said inhibit circuit carries out an inhibit operation in which data including error data read from a defective memory cell is inhibited from entering said vertical or horizontal parity generator; and

said redundant-cell parity generating circuit generates a redundant vertical or horizontal parity based on said read data not including said inhibited data plus the data from the redundant memory cell.

The object of the present invention is to provide a semiconductor memory device in which the redundant technique and the two-dimensional parity checking technique are combined, whereby not only previously determined hard error's along a predetermined bit (column) line but also other soft and hard errors occurring after the occurrence of previously determined hard errors can be corrected, and

whereby the yield of the device is improved.

This is achieved by adding a relatively simple circuit.

Reference is made, by way of example, to the accompanying drawings, wherein:

Figure 1 is a circuit diagram showing a conventional semiconductor memory device having a conventional error correction function;

Fig. 2 is a table diagram showing the contents of a parity-checking two-dimensional virtual matrix in a data selector in the device shown in Fig. 1;

Fig. 3 is a circuit diagram showing a semiconductor memory device according to an embodiment of the present invention;

Fig. 4 is a circuit diagram showing an example of a basic constitution of an inhibit circuit in the device shown in Fig. 3;

Fig. 5 is a block diagram showing an example of an inhibit control circuit in the device shown in Fig. 3;

Fig. 6 is a circuit diagram showing a semiconductor memory device according to another embodiment of the present invention; and

Fig. 7 is a circuit diagram showing an example of an inhibit control circuit in the device shown in Fig. 6.

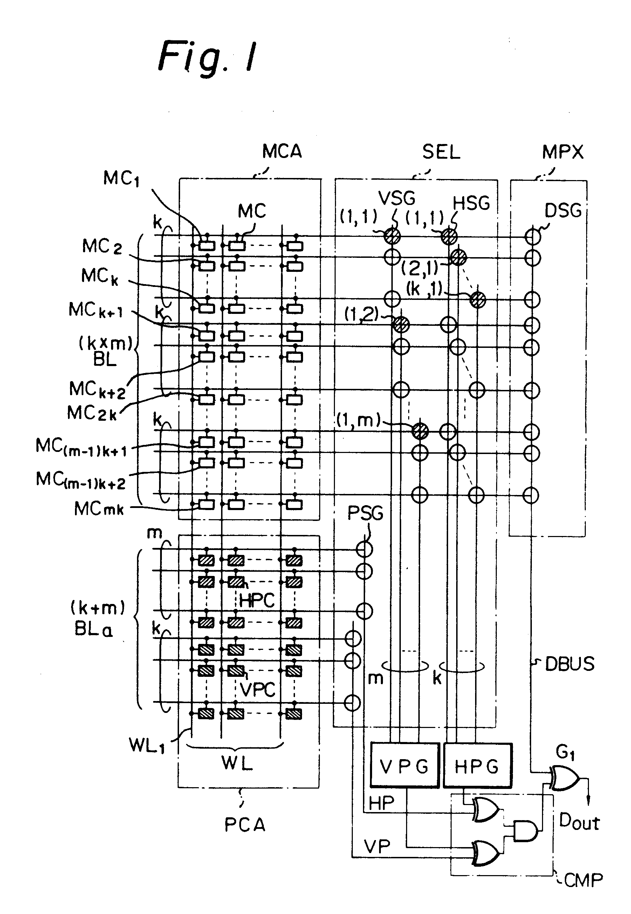

Before describing the embodiments of the present invention, a conventional semiconductor memory device employing a parity checking two-dimensional virtual matrix is described with reference to Fig. 1. In the Figure, MCA is a memory cell array in which a number of dynamic-type memory cells MC are arranged in a matrix fashion, wherein there are provided a number of $k \times m$ bit lines BL (wherein $k$ and $m$ are integers) in the horizontal (column) direction and a plurality of word lines WL in the vertical (row) direction. Simultaneously with a selection of one word line WL, data is read out from the memory cells MC of $(k \times m)$ bits connected to the selected word line WL. In a multiplexer MPX, only one bit thereof is selected in accordance with a selected bit line. $DSG_s$ are data selecting gates for effecting this selection of one bit, which is controlled by an output of a not-shown column decoder. DBUS is a data bus for transferring the data of the selected memory cell to an output EOR gate $G_1$.

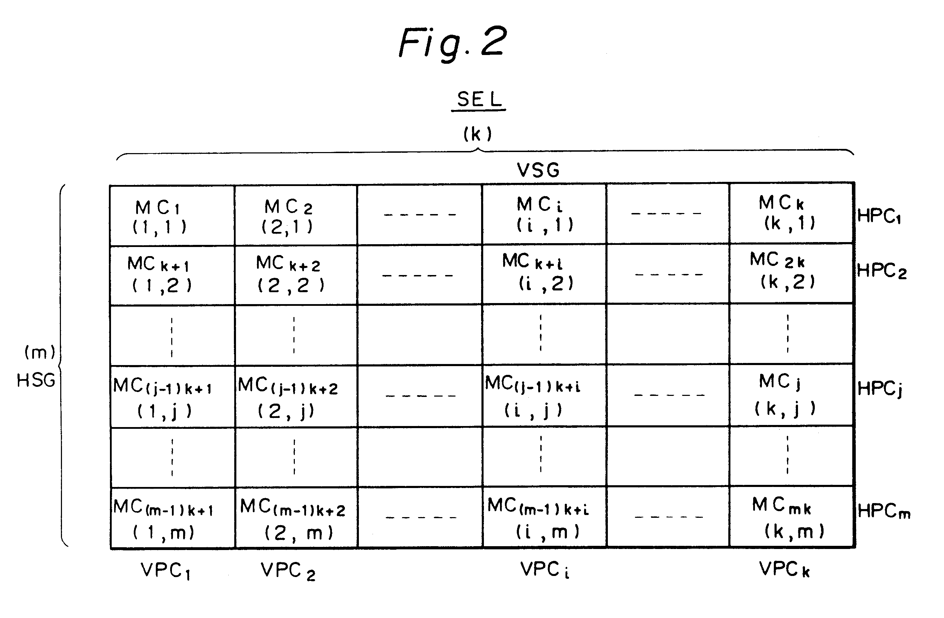

Simultaneously with the above-mentioned read-out operation, a selector SEL virtually (or logically) rearranges the data of all ($k \times m$ bits) memory cells connected to the selected word line into a parity-checking two-dimensional matrix (hereinafter referred to as an H-V matrix) with $m$ bits in the vertical direction and $k$ bits in the horizontal direction. The contents of the H-V matrix are diagramatically shown in Fig. 2. In the data selector SEL, VSG is a vertical select gate for selecting $m$-bit data on a selected vertical row of the H-V matrix; and HSG is a horizontal select gate for selecting $k$-bit data on a selected horizontal column of the H-V matrix. Assume that a memory cell $MC_{(j-1)k+i}$ connected to the left-most word line $WL_1$ is selected. Then, the vertical select gate VSG selects, by a not shown decoder, $m$ number of memory cells $MC_i$, $MC_{k+i}$, ..., $MC_{(j-1)k+i}$, ..., and $MC_{(m-1)k+i}$ virtually arranged on the $i$-th row of the H-V matrix shown in Fig. 2; and the horizontal select gate HSG selects, by a not-shown decoder, $k$ number of memory cells $MC_{(j-1)k+1}$, $MC_{(j-1)k+2}$, ..., $MC_{(j-1)k+i}$, ..., and $MC_j$ virtually arranged on the $j$-th column of the H-V matrix shown in Fig. 2. Examples of the memory cells selected by the vertical select gate VSG and the horizontal select gate HSG, when $i = 1$ and $j = 1$, for example, are illustrated by shaded circles in Fig. 1. The selected $m$ bits from the vertical select gate VSG are intput to a vertical parity generator VPG; and the selected $k$ bits from the horizontal select gate HSG are input to a horizontal parity generator HPG. The vertical parity generator VPG generates a vertical parity for the $m$ bits; and the horizontal parity generator HPG generates a horizontal parity for the $k$ bits.

PCA is a parity cell array including parity cells each storing a correct vertical parity or a correct horizontal parity. The correct parities have been previously written into the parity cells during the writing of data into all of the memory cells MC in the memory cell array MCA. In the construction of the parity cell array PCA, there are $m$ bits of horizontal parity cells HPC and $k$ bits of vertical parity cells VPC connected to each word line WL. $BL_a$ represents $(k+m)$ bit lines related to these cells HPC and VPC. When the memory cell, for example, $MC_{(j-1)k+i}$ is selected, $j$-th bit line in the $m$ bit lines $BL_a$ is selected; and $i$-th bit line in the $k$ bit lines $BL_a$ is selected so that a horizontal parity cell

HPC$_j$ and a vertical parity cell VPC$_i$ is selected (see Fig. 2). This selection of the parity cells is carried out by parity select gates PSG$_s$ in the data data selector SEL.

A comparator CMP compares the vertical parity output from the vertical parity generator VPG with the correct vertical parity output from the vertical parity cell VPC$_i$; and compares the horizontal parity output from the horizontal parity generator HPG with the correct horizontal parity output from the horizontal parity cell HPC$_j$. The comparator outputs "0" when these coincide and outputs "1" when they do not coincide. The output "1" of the comparator CMP is generated, in the H-V matrix shown in Fig. 2, when both of the vertical parity comparison and the horizontal parity comparison simultaneously represent the noncoincidence of the vertical parity of the read data with the correct vertical parity and of the horizontal parity of the read data with the correct horizontal parity. This means that the data read from the memory cell MC$_{(j-1)k+i}$ on the intersection of the selected vertical row and the selected horizontal column in the H-V matrix is not correct. Accordingly, for example, when the output "1" is input to the EOR gate G$_1$ having another input connected to the data bus DBUS, the read data at that time, that is, the read data generating an error, is inverted. Thus, corrected data D$_{out}$ can be obtained.

The error correction function by means of the above-described H-V matrix is effective not only for a soft error due to $\alpha$ rays but also for a hard error caused by a hard defect of a memory cell or for a bit line defect. However, there is a disadvantage in the above-described H-V matrix that the correctable error is only one bit in the memory cells belonging to a common horizontal or vertical parity group. That is, an error can be corrected only when a single bit in any H-V parity check data group in the above-mentioned H-V matrix is an error.

To correct a plurality of hard errors, a redundancy technique for remedy of the hard errors, for improving the yield, is publicly known. In a redundant construction in which a row redundancy, i.e., a redundant word line, is provided to replace a defective word line, the conventional technique can be combined with the redundant technique without any difficulty, whereby, hard defects along a predetermined defective word line can be remedied by the redundancy technique, and a soft error or a hard error caused after the determination of the defective word line can be realized by means of the two-dimensional parity checking using the above-mentioned H-V matrix. However, it is difficult to combine the construction of a column (bit line) redundancy with the above-described two-dimensional parity checking. When only the conventional column redundant technique is used, the switching from the defective column to the redundant column could be done merely by controlling the switching of the coupling to the data bus lines from the regular column (defective column) to the redundant column. However, to simply combine the two-dimensional parity checking with the column redundancy, the logic of the switching from the regular column (the memory cells connected to the selected bit line), which must be expressed in a number of H-V matrixes, to the redundant column, becomes too complex. That is, to effect the switching to the redundant column and to also effect the two-dimensional parity checking using the H-V matrix, a defective-column data must be inhibited from mixing with a column-data group from which a parity is to be taken, and the defective column data must be replaced by the redundant column data. Since the location of the generation of the defective column is indefinite, the correspondence between the redundant column and the H-V matrix is difficult to establish without assembling a switching control circuit, thus disadvantageously needing a great number of circuit elements to realize this very complex logic.

According to the present invention, however, the combination of the two-dimensional parity checking with the column redundancy can be realized by employing a relatively simple circuit.

The embodiments of the present invention are now described in the following.

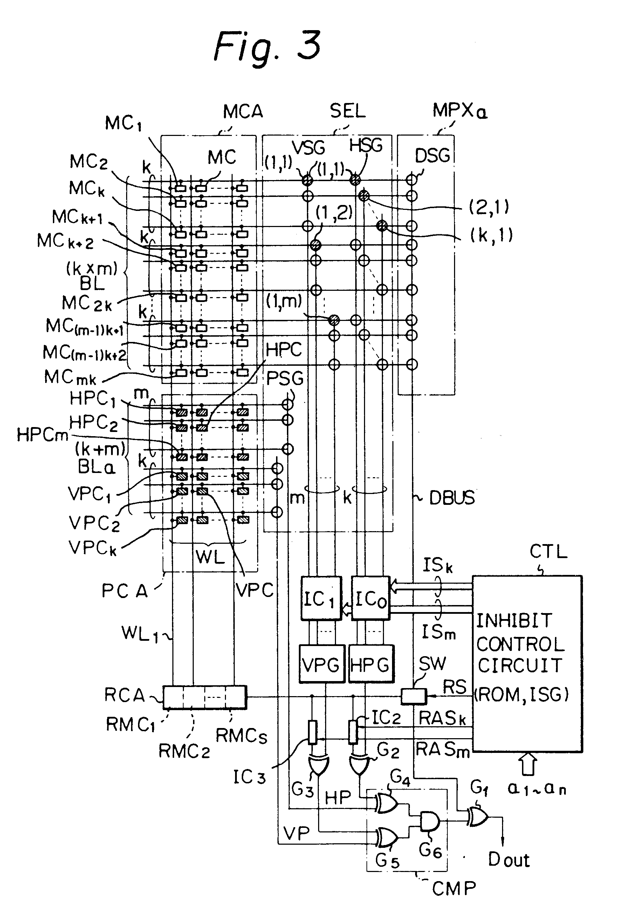

Figure 3 is a circuit diagram illustrating an embodiment of the present invention, in which the same portions as those in Fig. 1 are provided with the same symbols. In Fig. 3, in addition to the memory cell array MCA, the data selector SEL, the multiplexer MPX, the parity cell array PCA, the vertical parity generator VPG, the horizontal parity generator HPG, the comparator CMP, and the EOR gate G$_1$, which are included in the conventional device shown in Fig. 1, the semiconductor memory device of this embodiment shown in Fig. 3 further includes a redundant cell array RCA (redundant column) having an output connected to inputs of inhibit circuits IC$_2$ and IC$_3$; the outputs of the inhibit circuits IC$_2$ and IC$_3$ and the outputs of the horizontal and vertical parity generators HPG and VPG are respectively input to EOR gates G$_2$ and G$_3$; inhibit circuits IC$_0$ and IC$_1$ are inserted between the data selector SEL and the horizontal and vertical parity generators HPG and VPG; a switching circuit SW for switching between the output of the redundant cell array RCA and the data bus DBUS is connected between the data bus DBUS and an input of the EOR gate G$_1$; and, these inhibit circuits IC$_0$ through IC$_3$ and the switching circuit SW are controlled by an inhibit control circuit CTL. In the redundant cell array RCA, the same number s of redundant memory cells RMC$_1$, RMC$_2$, ..., and

$RMC_s$ as that of the memory cells connected to each regular bit line in the memory cell array MCA are arranged, each redundant memory cell being selected by a word line WL common to the memory cell array MCA. EOR gates $G_4$ and $G_5$ and AND gate $G_6$ constitute the comparator CMP, which is the same as that shown in Fig. 1. The outputs of the EOR gates $G_2$ and $G_3$ are, respectively, one of the inputs of the EOR gates $G_4$ and $G_5$. The other inputs of these EOR gates $G_4$ and $G_5$ respectively receive a horizontal parity HP and a vertical parity VP from the parity cell array PCA.

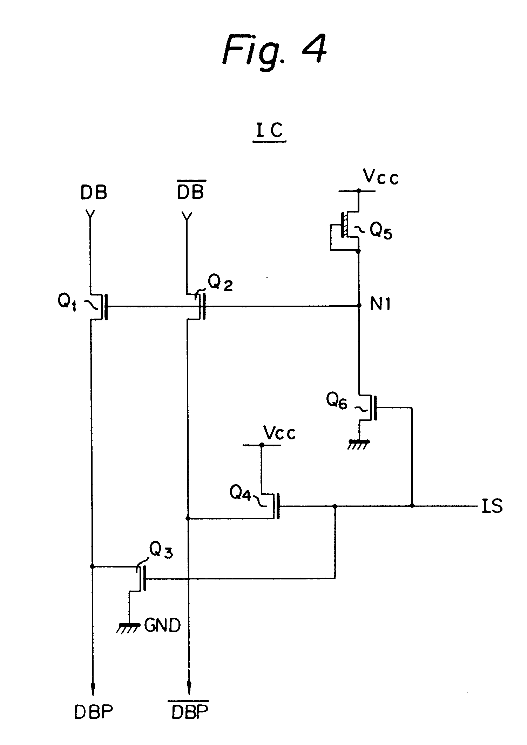

Figure 4 shows an example of a basic circuit for constituting the inhibit circuits $IC_0$ through $IC_3$. The inhibit circuits $IC_2$ and $IC_3$ are respectively formed by one set of the basic circuit; the inhibit circuit $IC_0$ is formed by k sets of the basic circuits; and the inhibit circuit $IC_1$ is formed by m sets of the basic circuits. DB represents an input of the basic circuit; and DBP represents an output of the basic circuit. In practice, since each of the outputs of the data selector SEL are complementary, an inverted input $\overline{DB}$ and inverted output $\overline{DBP}$ also occur. $V_{cc}$ is a power supply voltage for providing a high (H) level. GND is the ground potential for providing a low (L) level. MOS transistors $Q_1$ and $Q_2$ are for inhibiting inputs DB and $\overline{DB}$. When these transistors $Q_1$ and $Q_2$ are ON, the inputs DB and $\overline{DB}$ are permitted to pass through to the outputs DBP and $\overline{DBP}$. When the transistors $Q_1$ and $Q_2$ are OFF, the inputs DB and $\overline{DB}$ are inhibited and cannot pass through to the outputs DBP and $\overline{DBP}$. The control of these transistors $Q_1$ and $Q_2$ is effected by the output $N_1$ of a MOS inverter consisting of transistor $Q_5$ and $Q_6$. The transistor $Q_5$ is a depletion-type MOS transistor. That is, when an inhibit signal IS, given by the inhibit control circuit CTL, is at the high (H) level, the output $N_1$ of the inverter becomes low (L) level so that the transistors $Q_1$ and $Q_2$ are OFF, thus preventing the levels of the inputs DB and $\overline{DB}$ from passing through $Q_1$ and $Q_2$ to reach the outputs DBP and $\overline{DBP}$. Instead, the transistors $Q_3$ and $Q_4$ are turned ON so that the output DBP is fixed at the low (L) level and the output $\overline{DBP}$ is fixed at the high (H) level.

In the following, assume that the memory cell $MC_{(j-1)k+i}$ arranged on the intersection between a word line $WL_1$ and a bit line $BL_{(j-1)k+i}$, that is, on the coordinate (i, j) of the H-V matrix (see Fig. 2), is a previously determined defective memory cell. In other words, the bit line, to which the memory cell $MC_{(j-1)k+i}$ is connected, is the previously determined bit line.

The reading operation of the semiconductor memory device shown in Fig. 3 is described with reference to Figs. 2, 3, and 4.

(1) When the defective memory cell $MC_{(j-1)k+i}$ is selected to be read, the inhibit circuit $IC_0$ receives the error data from the i-th line in the k lines connected to the output of the horizontal select gate HSG; and the inhibit circuit $IC_1$ receives the error data from the j-th line in the m lines connected to the output of the vertical select gate VSG. In the inhibit circuit $IC_0$, the error data is received by the i-th basic circuit in the k sets of the basic circuits; and in the inhibit circuit $IC_1$, the error data is received by the j-th basic circuit in the m sets of the basic circuits. The i-th inhibit signal IS in the k bits of inhibit signal data $IS_k$ generated by the inhibit control circuit CTL is at the H level in accordance with the external address $a_1$ through $a_n$ for specifying the defective bit line. Therefore, the inhibit circuit $IC_0$ inhibits the error data from passing through to the i-th output in the k-bit output thereof; and the inhibit circuit $IC_1$ inhibits the error data from passing through to the j-th output in the m-bit output thereof. In other words, the j-th output of the inhibit circuit $IC_0$ and the k-th output of the inhibit circuit $IC_1$ are both fixed at the L level, i.e., at "0". Therefore, the horizontal parity generator HPG and the vertical parity generator VPG respectively generate horizontal and vertical parities of the read data, without taking the inhibited error data into account.

On the other hand, the inhibit control circuit CTL generates redundant-cell inhibit signals $RAS_k$ and $RAS_m$ of the H level in accordance with the external address for specifying the defective bit line. In response to the redundant-cell inhibit signals $RAS_k$ and $RAS_m$, the inhibit circuits $IC_2$ and $IC_3$ pass the correct data stored in the redundant memory cell array RCA. The correct data in the redundant memory cell $RMC_1$ is selected in response to the selected word line $WL_1$. The EOR gate $G_2$ generates a horizontal parity of the correct read data; and the EOR gate $G_3$ generates a vertical parity of the correct read data. In the comparator CMP, the EOR gate $G_4$ compares the horizontal parity of the correct data with the correct horizontal parity transferred from the parity cell array PCA through the parity select gate PSG; and the EOR gate $G_5$ compares the vertical parity of the correct data with the vertical parity transferred from the parity cell array PCA.

Unless the parity of the remaining data group obtained at the output of the horizontal parity generator HPG or the vertical parity generator VPG represents an error, the output of the comparator becomes "0". The switching circuit SW selects the correct data from the redundant cell array RCA in response to a redundant switching signal RS of "0" applied from the inhibit control circuit CTL. Thus, the correct data is read out at the output $D_{out}$. In conclusion, for

the previously determined hard errors, the redundant technique is effectively used to read correct data in the semiconductor memory device shown in Fig. 3.

(2) When a memory cell other than the defective memory cell $MC_{(j-1)k+i}$ is selected to be read, the reading operation is as follows. Assume that the selected memory cell is $MC_{(j-1)k+i+p}$ arranged on the coordinate $(i+p, j)$ of the H-V matrix. Referring to Fig. 2, the memory cell $MC_{(j-1)k+i+p}$ is arranged on the same horizontal column of the H-V matrix as the defective memory cell $MC_{(j-1)k+i}$, while the vertical row $(i+p)$ on which the selected memory cell is arranged is different from the vertical row i of the defective memory cell $MC_{(j-1)k+i}$. If a soft error or a hard error occurs on the selected memory cell $MC_{(j-1)k+i+p}$ after the determination of the defective bit line, the horizontal parity generator HPG and the vertical parity generator VPG receive the error data passed through the inhibit circuits $IC_0$ and $IC_1$. If the inhibit circuit $IC_0$ is not provided as in the conventional device shown in Fig. 1, the error data of the defective memory cell $MC_{(j-1)k+i}$ also is transferred through the i-th line of the k lines from the horizontal select gate HSG, so that the horizontal select gate HSG receives two error bits, causing the parity checking to become impossible.

However, since the inhibit circuits $IC_0$ and $IC_1$ are provided in this embodiment, the i-th inhibit signal IS in the k bits of the inhibit signal data $IS_k$ generated by the inhibit control circuit CTL is at the H level because the selected memory cell $MC_{(j-1)k+i+p}$ and the defective memory cell $MC_{(j-1)k+i}$ are both arranged on the same j-th horizontal column in the H-V matrix. Therefore, the inhibit circuit $IC_0$ inhibits the error data of the defective memory cell $MC_{(j-1)k+i}$ from passing therethrough.

Note, since the vertical row $(i+p)$ to which the selected memory cell $MC_{(j-1)k+i+p}$ belongs is different from the vertical row $(i)$ of the defective memory cell $MC_{(j-1)k+i}$, the inhibit circuit $IC_1$ does not effect the inhibit operation.

The redundant-cell inhibit signal $RAS_k$ is set to "1" in accordance with the external address $a_1$ through $a_n$, particularly with a part of the external address for specifying the j-th column in the H-V matrix, so that the inhibit circuit $IC_2$ passes the correct data from the redundant memory cell $RMC_1$ to the EOR gate $G_2$. The redundant-cell inhibit signal $RAS_m$ is set to "0" in accordance with another part of the external address for specifying the $(i+p)$-th row in the H-V matrix, so that the output of the inhibit circuit $IC_3$ is fixed to "0".

Thus, the EOR gate $G_2$ outputs a parity obtained based on the output of the horizontal parity generator HPG and the correct data from the redundant cell array RCA; and the EOR gate $G_3$ outputs a parity obtained based on only the output of the vertical parity generator VPG. The comparator CMP compares these parities with the horizontal parity HP and the vertical parity generated from the parity cell array PCA. If the read memory cell $MC_{(j-1)k+i+p}$ has a soft error or a hard error caused after the determination of the defective bit line, these parities do not coincide so that the comparator CMP outputs "1". If the read memory cell $MC_{(j-1)k+i+p}$ has no error, the comparator CMP outputs "0".

The switching circuit SW selects the data from the data bus DBUS in response to the redundant switching signal RS of "1". If the comparator CMP outputs "1", the EOR gate $G_1$ inverts the data from the data bus DBUS; and if the comparator CMP outputs "0", the EOR gate $G_1$ passes the data from the data bus DBUS without inversion. As a result, regardless of whether the read memory cell $MC_{(j-1)k+i+p}$ has a soft or hard error, correct data can be read at the output $D_{out}$.

When a memory cell $MC_{(j-1+q)k+i}$, arranged on the intersection of the $(j+q)$-th horizontal column and the i-th vertical row, is selected, the parity checking is also possible in the same way as described above.

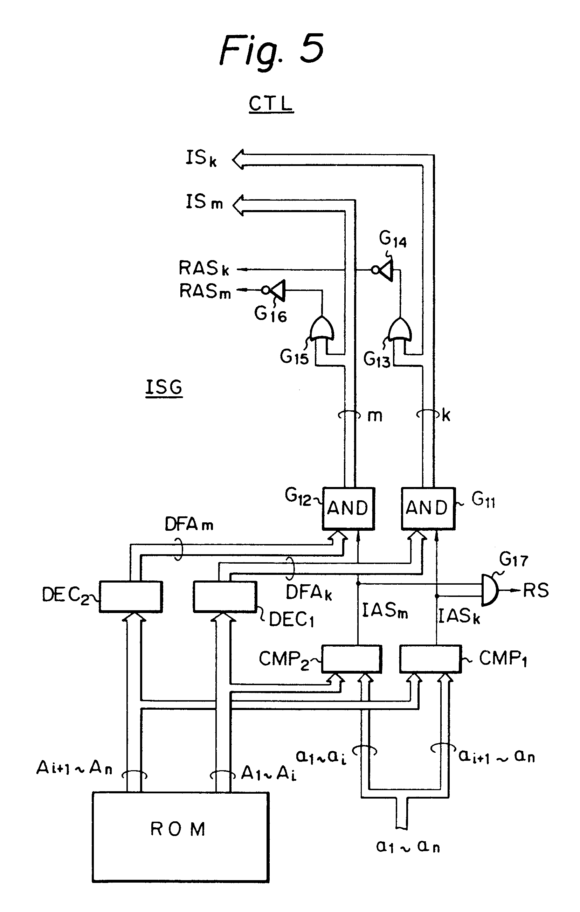

The signals $IS_k$, $IS_m$, $RAS_k$, $RAS_m$, and RS are generated by the inhibit control circuit CTL. Figure 5 shows a practical example of the inhibit control circuit CTL. In Fig. 5, the inhibit control circuit CTL comprises a read only memory (defective-column address memory) ROM for previously storing the address of the defective column line (defective bit line) having a hard defect (in the following, this address is referred to as a defective column address), and an inhibit signal generating circuit ISG which compares the defective column address with the external column address $a_1$ through $a_n$ for selecting a bit line BL, and when there is a coincidence, turns the corresponding inhibit signal IS to H. The inhibit signal generating circuit ISG includes two comparators $CMP_1$ and $CMP_2$, two decoders $DEC_1$ and $DEC_2$, two AND gates $G_{11}$ and $G_{12}$, two OR gates $G_{13}$ and $G_{15}$, two inverters $G_{14}$ and $G_{16}$, and an AND gate $G_{17}$.

The external address $a_1$ through $a_n$ for specifying a bit line are divided into two groups, i.e., $a_1$ through $a_i$ and $a_{i+1}$ through $a_n$, where $2^i = k$ and $2^{n-i} = m$. The first group of address $a_1$ through $a_i$ (in the following, referred to as a horizontal external-column address) is used for specifying the i-th vertical row from k rows in the H-V matrix shown in Fig. 2. The second group (in the following, referred to as a vertical external-column address) $a_{i+1}$ through $a_n$ is used for specifying the j-th column from $m$ columns in the H-V matrix shown in Fig. 2. The horizontal external-column address $a_1$ through $a_i$ is input to the vertical-address comparator $CMP_2$. The vertical external-column address $a_{i+1}$ through $a_n$ is input to a horizontal-address comparator $CMP_1$.

The defective-column address stored in the memory ROM is expressed by $A_1$ through $A_n$. The number of bits of the defective-column address $A_1$ through $A_n$ is, from the nature of the case, the same as the number of bits of the external column address $a_1$ through $a_n$. The defective-column address $A_1$ through $A_n$ is also divided into two groups, i.e., $A_1$ through $A_i$ and $A_{i+1}$ through $A_n$. The first group of the defective-column address $A_1$ through $A_i$ (horizontal defective-column address) is compared with the horizontal external-column address $a_1$ through $a_i$ by the vertical-address comparator $CMP_2$. The second group of the defective-column address (vertical defective-column address) $A_{i+1}$ through $A_n$ is compared with the second group of the external column address $a_{i+1}$ through $a_n$ by the horizontal-address comparator $CMP_1$. the horizontal-address comparator $CMP_1$ generates a horizontal column inhibit-activating signal $IAS_k$ of "1" when $a_{i+1}$ through $a_n$ coincides with $A_{i+1}$ through $A_n$. The vertical-address comparator $CMP_2$ generates a vertical column inhibit-activating signal $IAS_m$ of "1" when $a_1$ through $a_i$ coincides with $A_1$ through $A_i$.

The horizontal defective-column address $A_1$ through $A_i$ and the vertical defective-column address $A_{i+1}$ through $A_n$ are respectively transferred to a horizontal address decoder $DEC_1$ and a vertical address decoder $DEC_2$. The horizontal address decoder $DEC_1$ decodes the address $A_1$ through $A_n$ to provide a k-bit decoded signal $DFA_k$ in which only one bit is "1", which represents the position of the defective row in the H-V matrix shown in Fig. 2. The output $DFA_m$ of the vertical address decoder $DEC_2$ has $m$ bits in which, also, only one bit becomes "1", which represents the position of the defective row in the H-V matrix. The cross point on the H-V matrix, indicated by the outputs $DFA_k$ and $DFA_m$, represents the position of the defective memory cell. For example, when the bit line $BL_{(j-1)k+i}$ is defective and, therefore, the memory cell $MC_{(j-1)k+i}$ is defective, the i-th bit in the k-bit signal $DFA_k$ becomes "1", and the j-th bit in the m-bit signal $DFA_m$ becomes "1". In this case, the i-th column and the j-th row in the H-V matrix are defective.

When the horizontal column inhibit-activat-ing signal $IAS_k$ is applied to a horizontal-column AND gate $G_{11}$, that is, when the horizontal external-column address $a_1$ through $a_n$ coincides with the horizontal defective-column address $A_1$ through $A_n$, the decoded signal $DAF_k$ is passed through the AND gate $G_{11}$ so that, in the output signal $IS_k$ of k bits, only one bit (i-th bit) becomes "1". Also, when the vertical column inhibit-activating signal $IAS_m$ is applied to a vertical-column AND gate $G_{12}$, that is, when the vertical external-column address $a_{i+1}$ through $a_n$ coincides with the vertical defective-column address $A_{i+1}$ through $A_n$, the decoded signal $DFA_m$ is passed through the AND gate $G_{12}$ so that, in the output signal $IS_m$ of m bits, only one bit (j-th bit) becomes "1". When the inhibit-activating signals $IAS_k$ and $IAS_m$ are not generated because of noncoincidence of the external address and the defective address, all bits of the signals $IS_k$ and $IS_m$ are "0". The signals $IS_k$ and $IS_m$ are applied as inhibit signals to the inhibit circuits $IC_0$ and $IC_1$ (Fig. 3), respectively.

The inhibit signals $IS_k$ and $IS_m$ are also transferred to the inputs of OR gates $G_{13}$ and $G_{15}$, respectively. When one of the k bits in the inhibit signal $IS_k$ is "1", the output of the OR gate $G_{13}$ becomes "1". Also, when one of the m bits in the inhibit signal $IS_m$ is "1", the output of the OR gate $G_{15}$ becomes "1". In the other case when all bits of the inhibit signal $IS_k$ or $IS_m$ are "0", the output of the OR gate $G_{13}$ or $G_{15}$ is "0". The outputs of the OR gates $G_{13}$ and $G_{15}$ are respectively inverted by inverter gates $G_{14}$ and $G_{16}$ so that redundant-cell inhibit signals $RAS_k$ and $RAS_m$ are generated from the outputs of the inverters $G_{14}$ and $G_{16}$. The redundant-cell inhibit signals $RAS_k$ and $RAS_m$ are respectively applied to the inhibit circuits $IC_2$ and $IC_3$ (Fig. 3).

The inhibit signal IS shown in Fig. 4 is one of the k-bits of the inhibit signal $IS_k$, one of the m-bits of the inhibit signal $IS_m$, the redundant-cell inhibit signal $RAS_k$, or the redundant-cell inhibit signal $RAS_m$.

The redundant switching signal RS is generated when both of the inhibit-activating signals $IAS_k$ and $IAS_m$ become "1", that is, when the external address $a_1$ through $a_n$ coincides with the defective column address $A_1$ through $A_n$. In response to the signal RS, the switching circuit SW (Fig. 3) selects from the redundant cell array RCA the correct data to be transferred to the EOR gate $G_1$.

As is apparent from the foregoing description, according to the first embodiment, parity checking can be carried out and correct data can be read not only when the redundant memory cell is accessed in place of the previously determined defective memory cell, but also when another memory cell is accessed which may have a soft or a hard error produced after the determination of the defective bit line.

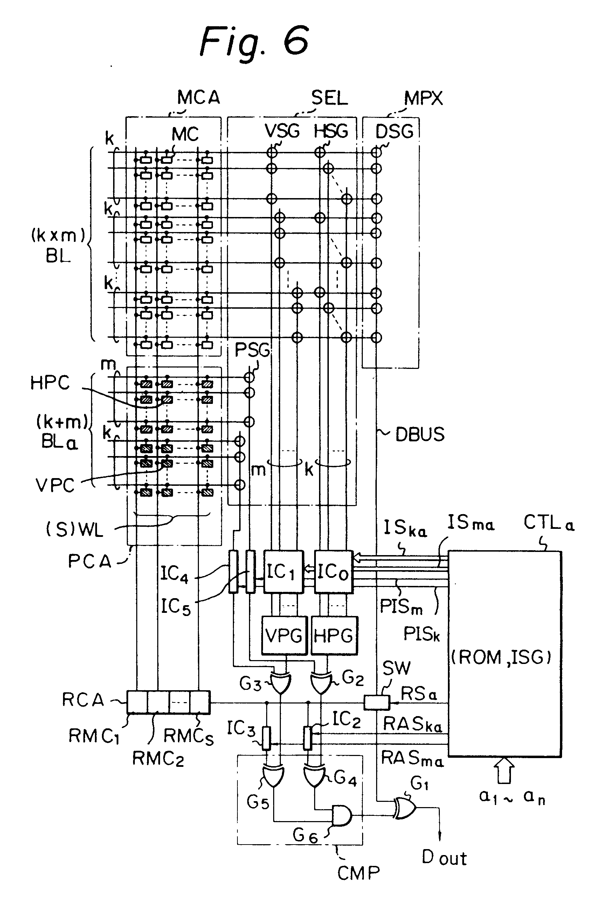

Figure 6 is a circuit diagram showing another embodiment of the present invention in which a hard defect in the parity cell array PCA can be remedied. In the first embodiment shown in Fig. 3, the case where a memory cell MC is replaced by a redundant memory cell RMC was shown. In the second embodiment shown in Fig. 6, this concept is further expanded so that not only a defective memory cell MC but also a defective parity cell connected to the same defective bit line can be replaced by the redundant memory cell. Practically, an inhibit circuit $IC_4$ for the horizontal parity cells HPC and an inhibit circuit $IC_5$ for the vertical parity cells VPC are added, the outputs of which, and the outputs of the parity generators HPG and VPG, are, at first, input to the EOR gates $G_2$ and $G_3$. The additional inhibit circuits $IC_4$ and $IC_5$ are respectively controlled by additional parity inhibit signals $PIS_m$ and $PIS_k$. The outputs of the EOR gates $G_2$ and $G_3$ are connected to one of the inputs of the EOR gates $G_4$ and $G_5$, respectively. The output of the redundant cell array RCA is connected, through the inhibit circuit $IC_2$, to another input of the EOR gate $G_4$, and, through the inhibit circuit $IC_3$, to another input of the EOR gate $G_5$.

A modified inhibit control circuit $CTL_a$ generates the inhibit signals $PIS_m$ and $PIS_k$, as well as inhibit signals $IS_{ka}$, $IS_{ma}$, and a redundant parity cell switching signal $RS_a$, which are similar to the inhibit signals $IS_k$, $IS_m$, and the redundant switching signal RS shown in Fig. 3.

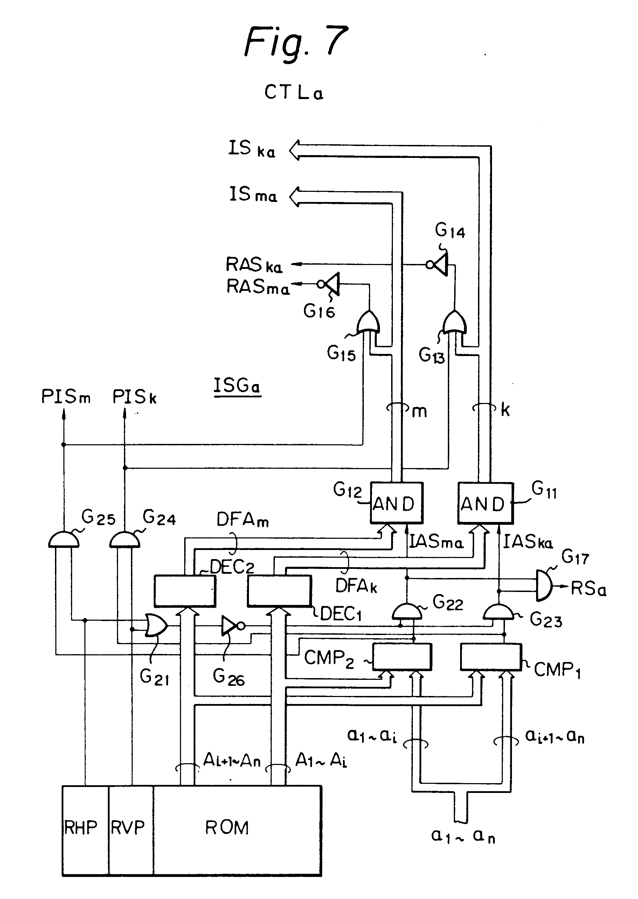

Figure 7 is a circuit diagram illustrating an example of the modified inhibit control circuit $CTL_a$. In Fig. 7, in addition to the elements in the inhibit control circuit shown in Fig. 5, an OR gate $G_{21}$, an inverter gate $G_{26}$, and AND gates $G_{22}$ through $G_{25}$ are provided. The ROM stores, in addition to the defective column address $A_1$ through $A_n$ of the defective bit line of the defective memory cells, data RVP and RHP. When the data RHP or RVP is "1", the parity cells arranged on the defective address $A_1$ through $A_i$ or $A_{i+1}$ through $A_n$ are defective, respectively.

By this constitution, the parity inhibit signal $PIS_k$ is generated when both conditions, i.e., when the vertical external-column address $a_{i+1}$ through $a_n$ coincides with the vertical defective-column address $A_{i+1}$ through $A_n$ and when the data RVP is "1" expressing that the vertical parity cells VPC are defective, are satisfied; and the parity inhibit signal $PIS_m$ is generated when the horizontal external-column address $a_1$ through $a_i$ coincides with the horizontal defective-column address $A_1$

through $A_i$ and when the data RHP is "1" expressing that the horizontal parity cells VHC are defective. The modified inhibit-activating signal $IAS_{ka}$ of "1" is generated in both conditions when the parity cells are not defective (RHP = "0" and RVP = "0") and when the external address $a_{i+1}$ through $a_n$ coincides with the defective address $A_{i+1}$ through $A_n$; and the modified inhibit-activating signal $IAS_{ma}$ of "1" is generated in both conditions when the data RHP and RVP are "0" and when the external address $a_1$ through $a_i$ coincides with the defective address $A_1$ through $A_i$. The AND gate $G_{11}$ passes the decoded output $DFA_k$ which becomes the modified inhibit signal $IS_{ka}$ in response to the inhibit-activating signal $IAS_{ka}$ of "1", and the AND gate $G_{12}$ passes the decoded output $DFA_m$ which becomes the modified inhibit signal $IS_{ma}$ in response to the inhibit-activating signal $IAS_{ma}$ of "1". The modified inhibit signal $RAS_{ka}$ is "1" when all of the bits in the signal $IS_{ka}$ and the parity inhibit signal $PIS_k$ are "0"; and the signal $RAS_{ka}$ is "0" when at least one of the bits in the signals $IS_{ka}$ and $PIS_k$ is "1". The modified inhibit signal $RAS_{ma}$ is "1" when all of the bits in the signal $IS_{ma}$ and the signal $PIS_m$ are "0"; and the $RAS_{ma}$ is "0" when at least one of the bits in the signals IS and $PIS_m$ is "1". The redundant parity cell switching signal $SW_a$ is generated when both data RHP and RVP are "0" and when the external address $a_1$ through $a_n$ coincides with the defective address $A_1$ through $A_n$.

Referring back to Fig. 6, the operation of the semiconductor memory device according to the second embodiment is described in the following.

(1) When the parity cell array PCA does not include a hard error, the data RHP and RVP (Fig. 7) are "0" and thus the parity inhibit signals $PIS_k$ and $PIS_m$ are "0". Therefore, the inhibit circuits $IC_4$ and $IC_5$ pass the horizontal parity and the vertical parity therethrough.

(i) In this state, when the external address $a_1$ through $a_n$ does not coincide with the defective address $A_1$ through $A_n$, the comparators $CMP_1$ and $CMP_2$ output "0" and thus the inhibit-activating signals $IAS_{ka}$ and $IAS_{ma}$ are "0", fixing all bits in the inhibit signals $IS_{ka}$ and $IS_{ma}$ at "0", and fixing the redundant address signals $RAS_{ka}$ and $RAS_{ma}$ at "1" (see Fig. 7). As a result, the outputs of the inhibit circuits $IC_2$ and $IC_3$ are fixed at "0" in response to the "0" of the signals $RAS_{ka}$ and $RAS_{ma}$. Accordingly, the EOR gates $G_4$ and $G_5$ pass the horizontal parity and the vertical parity without inversion to the inputs of the AND gate $G_6$. The switch circuit SW selects the data bus DBUS in response to the redundant selecting signal $RS_a$, which is "0" because the comparators $CMP_1$ and $CMP_2$ output "0".

(ii) When the external address $a_1$ through $a_n$ coincides with the defective address $A_1$ through $A_n$, the comparators $CMP_1$ and $CMP_2$ output "1". The data RVP and RHP of "0" are inverted by the inverter gate $G_{26}$. Therefore, the AND gates $G_{22}$ and $G_{23}$ output "1". As a result, the signal $DFA_k$ is passed through the AND gate $G_{11}$ to become the signal $IS_{ka}$; the signal $DFA_m$ is passed through the AND gate $G_{12}$ to become the signal $IS_{ma}$; the signals $RAS_{ka}$ and $RAS_{ma}$ are "1" because the signals $IS_{ka}$ and $IS_{ma}$ respectively include at least one bit of "1"; the signal $RS_a$ becomes "1"; and the signals $PIS_k$ and $PIS_m$ are "0" (see Fig. 7). Thus, the correct data from the data bus DBUS can be read at the output $D_{out}$ in a similar way to the first embodiment.

(2) Contrary to this, when the parity cell array PCA has a hard defect, the redundant cell array RCA is used in place of the parity cell array PCA, and, to this end, when the defective bit is read from the parity cell array PCA, the fixed "0" is output from the inhibit circuit $IC_4$ or $IC_5$ in response to "1" of the parity inhibit signal $PIS_k$ or $PIS_m$. And, instead, the inhibit circuit $IC_2$ or $IC_3$ is made to through state in response to "0" of the redundant address signal $RAS_{ka}$ or $RAS_{ma}$, enabling the use of the output of the redundant cell array RCA as the parity data. That is, when the external address $a_1$ through $a_n$ coincides with the defective address $A_1$ through $A_n$, and when the RVP or RHP is "1", the AND gates $G_{22}$ or $G_{23}$ outputs "0" because the output of the inverter gate $G_{26}$ is "0". Therefore, the signal $IS_{ka}$ and $IS_{ma}$ are "0"; the signal $RS_a$ is "0"; the signals $PIS_k$ and $PIS_m$ are "1"; and the signals $RAS_{ka}$ and $RAS_{ma}$ are "0" (see Fig. 7).

From the foregoing description, it will be apparent that, according to the present invention, in a semiconductor memory device having a function of parity checking by employing an H-V matrix, since previously determined hard defects can be replaced by redundant memory cells, the parity checking function can be advantageously used for a soft error or a hard error occurring after the determination of the previously determined hard defects.

Further, the yield of the semiconductor memory device having a function of parity checking with an H-V matrix can be improved by employing a redundant memory cell array.

Still further, the redundant technique and the parity checking technique using an H-V matrix can be combined by adding a relatively simple circuit.

As explained above, an embodiment of the present invention can provide a semiconductor memory device comprising an error correcting circuit employing a virtual two-dimensional matrix for correcting read data, and a redundant memory cell to replace a defective memory cell, wherein when the selected memory cell has a previously determined hard error, the selected memory cell is replaced by the redundant memory cell, and when the selected memory cell has a soft error or a hard error occurring after the determination of the previously determined hard error, the read data is corrected by the error correcting circuit.

The embodiment of the present invention provides a semiconductor memory device having an error correction function, which device can process both a soft error and a hard error by adding an error correction code (ECC) and redundant bits.

## Claims

1. A semiconductor memory device comprising:-
   a memory cell array (MCA) including a plurality of memory cells arranged in a matrix;
   an error correcting circuit including:-
   a data selector (SEL), operatively connected to said memory cell array, for receiving read data from a plurality of memory cells including a selected memory cell, and for selectively outputting a part of said read data which forms horizontal and vertical parity checking groups corresponding to a parity-checking two-dimensional virtual matrix (VSG, HSG);
   a vertical parity generator (VPG) and a horizontal parity generator (HPG), operatively connected to the data selector, for generating a vertical and horizontal parity of said data group, respectively;
   a parity storing memory (PCA) for storing a previously determined vertical and horizontal parity;
   a comparator (CMP), operatively connected to said vertical and horizontal parity generators and to said parity storing memory, for comparing the outputs thereof to detect an error in said read data;
   a data correcting gate ($G_1$) for correcting said error in said read data in response to an output of said comparator (CMP); and
   a data bus (DBUS) for transferring read data from said data selector (SEL) to said data correcting gate ($G_1$); characterised by:-
   a redundant memory cell (RMC) for replacing a defective memory cell of said memory cell array (MCA);
   a switching circuit (SW) for switching between the output of the redundant memory cell (RMC) and the data bus (DBUS), connected between the data bus (DBUS) and an input of the data correcting gate ($G_1$); and

an inhibit and parity generating circuit ($IC_0$-$IC_3$, CTL, $G_2$, $G_3$), comprising:-

an inhibit circuit ($IC_0$, $IC_1$), operatively connected between said data selector (SEL) and said vertical and horizontal parity generators (VPG, HPG);

a redundant-cell parity generating circuit ($IC_2$, $IC_3$, $G_2$, $G_3$), operatively connected to said redundant memory cell and to said vertical and horizontal parity generators (VPG, HPG); and

an inhibit control circuit (CTL), operatively receiving an external address signal for selecting a memory cell in said memory cell array, and operatively connected to said switching circuit (SW), to said inhibit circuit ($IC_0$, $IC_1$) and to said redundant-cell parity generating circuit ($IC_2$, $IC_3$, $G_2$, $G_3$);

said inhibit control circuit (CTL) being operable to generate, in response to an external address which specifies a defective memory cell, a redundant switching signal (RS) to be applied to said switching circuit (SW), inhibit signals (IS) to be applied to said inhibit circuit ($IC_0$, $IC_1$), and a control signal (RAS) to be applied to said redundant-cell parity generating circuit ($IC_2$, $IC_3$, $G_2$, $G_3$); whereby:-

said switching circuit (SW) selects the correct data from the redundant memory cell (RMC);

said inhibit circuit ($IC_0$, $IC_1$) carries out an inhibit operation in which data including error data read from a defective memory cell is inhibited from entering said vertical or horizontal parity generator; and

said redundant-cell parity generating circuit ($IC_2$, $IC_3$, $G_2$, $G_3$) generates a redundant vertical or horizontal parity based on said read data not including said inhibited data plus the data from the redundant memory cell.

2. A semiconductor memory device as set forth in claim 1, wherein said data selector (SEL) comprises:-

a vertical select gate (VSG), operatively connected between said memory cell array and said vertical parity generator, for selecting m-bit data on a selected vertical row of said parity-checking two-dimensional virtual matrix from a selected kxm bits input from said memory cell array to said data selector; and

a horizontal select gate (HSG), operatively connected between said memory cell array and said horizontal parity generator, for selecting k-bit data on the horizontal row on said parity-checking two-dimensional virtual matrix from said selected kxm bits.

3. A semiconductor memory device as set forth in claim 2, wherein said inhibit circuit comprises:-

a first inhibit circuit ($IC_0$), operatively connected between said horizontal select gate and said horizontal parity generator, for inhibiting one of said k-bits from passing from said horizontal select gate into said horizontal parity generator in response to a first inhibit signal ($IS_k$) of said inhibit signals (IS), said first inhibit signal being generated in said inhibit control circuit when said defective memory cell is accessed; and

a second inhibit circuit ($IC_1$), operatively connected between said vertical select gate and said vertical parity generator, for inhibiting one of said m bits from passing from said vertical select gate into said vertical parity generator in response to a second inhibit signal ($IS_m$) of said inhibit signals (IS), said second inhibit signal being generated when said defective memory cell is accessed.

4. A semiconductor memory device as set forth in claim 3, wherein said redundant-cell parity generating circuit comprises:-

a third inhibit circuit ($IC_2$), operatively connected to said redundant memory cell, for inhibiting data read from said redundant memory cell from passing through said third inhibit circuit in response to a third inhibit signal ($RAS_k$) of said inhibit signals, said third inhibit signal being generated when said defective memory cell is not accessed;

a fourth inhibit circuit ($IC_3$), operatively connected to said redundant memory cell, for inhibiting data read from said redundant memory cell from passing through said fourth inhibit circuit in response to a fourth inhibit signal ($RAS_m$) of said inhibit signals, said fourth inhibit signal being generated when said defective memory cell is not accessed;

a first redundant parity gate ($G_2$) having inputs operatively connected to the outputs of said horizontal parity generator and said third inhibit circuit, for generating said redundant horizontal parity; and

a second redundant parity gate ($G_3$) having inputs operatively connected to the outputs of said vertical parity generator and said redundant memory cell, for generating said redundant vertical parity.

5. A semiconductor memory device as set forth in claim 4, wherein said comparator comprises:-

a horizontal parity gate ($G_4$), having inputs operatively connected to the output of said first redundant parity gate and to said parity storing memory, for effecting a horizontal parity processing based on said redundant horizontal parity and said previously determined horizontal parity;

a vertical parity gate ($G_5$), having inputs operatively connected to the output of said second redundant parity gate and to said parity storing memory, for effecting a vertical parity processing based on said redundant vertical parity and said previously determined vertical parity; and

an AND gate ($G_6$) having inputs operatively connected to the outputs of said horizontal parity gate ($G_4$) and said vertical parity gate ($G_5$), for providing a coincidence signal when said outputs of said horizontal parity gate and said vertical parity gate coincide.

6. A semiconductor memory device as set forth in claim 4 or 5, wherein said inhibit control circuit comprises:-

a defective-column address memory (ROM) having a storing area for storing the defective column address ($A_1$-$A_n$) of said defective memory cell; and

an inhibit-signal generating circuit (ISG), operatively receiving said defective column address of said defective memory cell and an external column address signal for specifying a memory cell, for providing said inhibit signals when said defective column address coincides with said external column address.

7. A semiconductor memory device as set forth in claim 6, wherein said inhibit-signal generating circuit comprises:

a horizontal address decoder ($DEC_1$) operatively receiving a part ($A_1$-$A_i$) of said defective column address from said defective-column address memory, for providing $\underline{k}$ bits of decoded output;

a vertical address decoder ($DEC_2$) operatively receiving another part ($A_{i+1}$-$A_n$) of said defective column address from said defective-column address memory, for providing $\underline{m}$ bits of decoded output;

a first comparator ($CMP_1$) for comparing said another part ($A_{i+1}$-$A_n$) of said defective column address with a corresponding part ($a_{i+1}$-$a_n$) of said external column address;

a second comparator ($CMP_2$) for comparing said part ($A_1$-$A_i$) of said defective column address with a corresponding part ($a_1$-$a_i$) of said external column address;

a first AND gate ($G_{11}$) for passing said k-bits of decoded output from said horizontal address decoder through said first AND gate only when said first comparator generates a first coincidence signal ($IAS_k$), one of said k-bits passed through said first AND gate being said first inhibit signal ($\overline{IS_k}$);

a second AND gate ($G_{12}$) for passing said m-bits of decoded output from said vertical address decoder through said second AND gate only when said second comparator generates a second coincidence signal ($IAS_m$), one of said m-bits passed through said second AND gate being said second inhibit signal ($\overline{IS_m}$);

a first inverter gate ($G_{14}$) for inverting said first inhibit signal so as to provide said third inhibit signal ($RAS_k$); and

a second inverter gate ($G_{16}$) for inverting said second inhibit signal so as to provide said fourth inhibit signal ($RAS_m$).

8. A semiconductor memory device as set forth in claim 3, wherein said redundant-cell-parity generating circuit comprises:

a third inhibit circuit ($IC_4$), operatively connected to said parity storing memory, for inhibiting data read from said parity storing memory from passing through said third inhibit circuit in response to a third inhibit signal ($PIS_m$), said third inhibit signal being generated when said previously determined horizontal parity has a hard error;

a fourth inhibit circuit ($IC_5$), operatively connected to said parity storing memory, for inhibiting data read from said parity storing memory from passing through said fourth inhibit circuit in response to a fourth inhibit signal ($PIS_k$), said fourth inhibit signal being generated when said previously determined vertical parity has a hard defect;

a first parity gate ($G_2$) having inputs operatively connected to the outputs of said horizontal parity generator and said third inhibit circuit, for generating a horizontal parity;

a second parity gate ($G_3$) having inputs operatively connected to the outputs of said vertical parity generator and said fourth inhibit circuit, for generating a vertical parity;

a fifth inhibit circuit ($IC_2$), operatively connected to said redundant memory cell, for inhibiting data read from said redundant memory cell from passing through said third inhibit circuit in response to a fifth inhibit signal ($RAS_{ka}$) of said inhibit signals, said fifth inhibit signal being generated in both conditions wherein said defective memory cell is not accessed and said previously determined vertical parity has a hard defect;

a sixth inhibit circuit ($IC_3$), operatively connected to said redundant memory cell, for inhibiting data read from said redundant memory cell from passing through said sixth inhibit circuit in response to a sixth inhibit signal ($RAS_m$) of said inhibit signals, said sixth inhibit signal being generated in both conditions wherein said defective memory cell is not accessed and said previously determined horizontal parity has a hard defect;

a horizontal parity gate ($G_4$), having inputs operatively connected to the output of said first parity gate and to the output of said fifth inhibit circuit, for effecting a horizontal parity processing;

a vertical parity gate ($G_5$), having inputs operatively connected to the output of said second parity gate and to the output of said sixth inhibit circuit; and, for effecting a vertical parity processing;

an AND gate ($G_6$) having inputs operatively connected to the outputs of said horizontal parity gate ($G_4$) and said vertical parity gate ($G_5$), for providing a coincidence signal when said outputs of said horizontal parity gate and said vertical parity gate coincide.

9. A semiconductor memory device as set forth in claim 8, wherein said inhibit control circuit comprises:

a defective-column address memory (ROM) having a storing area for storing the defective column address ($A_1$-$A_n$) of said defective memory cell and another storing area (RHP, VHP) for storing parity data expressing whether said previously determined vertical or horizontal parity has a hard defect or not;

an inhibit-signal generating circuit (ISG), operatively receiving said defective column address ($a_1$-$a_n$) of said defective memory cell, said parity data (RHP, VHP), and an external column address signal for specifying a memory cell, for providing said inhibit signals when said defective column address coincides with said external column address and when said parity data expresses that said previously determined vertical or horizontal parity does not have a hard defect.

10. A semiconductor memory device as set forth in claim 9, wherein said inhibit-signal generating circuit comprises:

a horizontal address decoder ($DEC_1$) operatively receiving a part ($A_1$-$A_i$) of said defective column address from said defective-column address memory, for providing k-bits of decoded output;

a vertical address decoder ($DEC_2$) operatively receiving another part of said defective column address from said defective-column address memory, for providing m-bits of decoded output;

a first comparator ($CMP_1$) for comparing said another part ($A_{i+1}$-$A_n$) of said defective column address with a corresponding part ($a_{i+1}$-$a_n$) of said external column address;

a second comparator ($CMP_2$) for comparing said part ($A_1$-$A_i$) of said defective column address with a corresponding part ($a_1$-$a_i$) of said external column address;

a first AND gate ($G_{11}$) for passing said k-bits of decoded output from said horizontal address decoder through said first AND gate in both conditions wherein said first comparator generates a coincidence signal ($IAS_{ka}$) and said parity data expresses a hard defect in the previously determined parity (RHP, VHP), one of said k-bits passed through said first AND gate being said first inhibit signal ($IS_k$);

a second AND gate ($G_{12}$) for passing said m-bits of decoded output from said vertical address decoder through said second AND gate in both conditions wherein said second comparator (COMP2) generates a coincidence signal and said parity data expresses a hard defect in the previously determined parity (RHP, VHP), one of said m-bits passed through said second AND gate being said second inhibit signal ($IS_m$);

a first inverter gate ($G_{14}$) for inverting a logic OR of said fourth inhibit signal ($PIS_k$) and said first inhibit signal so as to provide said sixth inhibit signal ($RAS_k$); and

a second inverter gate ($G_{16}$) for inverting a logic OR of said third inhibit signal ($PIS_m$) and said second inhibit signal so as to provide said fifth inhibit signal ($RAS_m$).

**Revendications**

1. Dispositif de mémoire à semiconducteur comprenant:

un réseau de cellules de mémoire (MCA) incluant une pluralité de cellules de mémoire disposées en matrice;

un circuit correcteur d'erreurs incluant:

un sélecteur de données (SEL), connecté activement audit réseau de cellules de mémoire, pour recevoir des données lues dans une pluralité de cellules de mémoire incluant une cellule de mémoire sélectionnée, et pour sortir sélectivement une partie desdites données lues qui constitue des groupes de contrôle de parités horizontales et verticales correspondant à une matrice virtuelle bidimensionnelle de contrôle de parités (VSG,HSG);

un générateur de parités verticales (VPG) et un générateur de parités horizontales (HPG), connectés activement au sélecteur de données, pour générer respectivement une parité verticale et une parité horizontale dudit groupe de données;

une mémoire de mémorisation de parités (PCA) pour mémoriser une parité verticale et une parité horizontale déterminées précédemment;

un comparateur (CMP), connecté activement auxdits générateurs de parités verticales et horizontales et à ladite mémoire de mémorisation de parités, pour comparer leurs signaux de sortie afin de détecter une erreur dans lesdites données lues;

une porte de correction de données ($G_1$) pour corriger ladite erreur dans lesdites données lues en réponse à un signal de sortie dudit comparateur (CMP); et

un bus de données (DBUS) pour transférer les données lues dudit sélecteur de données (SEL) jusqu'à ladite porte de correction de données ($G_1$); caractérisé par:

une cellule de mémoire redondante (RMC) pour remplacer une cellule de mémoire défectueuse dudit réseau de cellules de mémoire (MCA);

un circuit commutateur (SW) pour exécuter une commutation entre la sortie de la cellule de mémoire redondante (RMC) et le bus de données (DBUS), connecté entre le bus de données (DBUS) et une entrée de la porte de correction de données ($G_1$); et

un circuit générateur de signaux d'interdiction et de parités ($IC_0$-$IC_3$,CTL, $G_2$, $G_3$), comprenant:

un circuit d'interdiction ($IC_0$,$IC_1$), connecté activement entre ledit sélecteur de données (SEL) et lesdits générateurs de parités verticales et horizontales (VPG, HPG);

un circuit générateur de parités de cellule redondante ($IC_2$,$IC_3$,$G_2$,$G_3$), connecté activement à ladite cellule de mémoire redondante et auxdits générateurs de parités verticales et horizontales (VPG,HPG); et

un circuit de commande d'interdiction (CTL), recevant à l'état actif un signal d'adresse externe pour la sélection d'une cellule de mémoire dans ledit réseau de cellules de mémoire, et étant connecté activement audit circuit commutateur (SW), audit circuit d'interdiction ($IC_0$,$IC_1$) et audit circuit générateur de parités de cellule redondante ($IC_2$,$IC_3$,$G_2$,$G_3$);

ledit circuit de commande d'interdiction (CTL) pouvant être rendu actif pour engendrer, en réponse à une adresse externe qui spécifie une cellule de mémoire défectueuse, un signal de commutation redondant (RS) à appliquer audit circuit commutateur (SW), des signaux d'interdiction (IS) à appliquer audit circuit d'interdiction ($IC_0$,$IC_1$), et un signal de commande (RAS) à appliquer audit circuit générateur de parités de cellule redondante ($IC_2$,$IC_3$,$G_2$,$G_3$);

au moyen desquels:

ledit circuit commutateur (SW) sélectionne la donnée correcte dans la cellule de mémoire redondante (RMC);

ledit circuit d'interdiction ($IC_0$,$IC_1$) exécute une opération d'interdiction dans laquelle les données incluant une donnée erronée lue dans une cellule de mémoire défectueuse sont interdites d'entrer dans ledit générateur de parités verticales ou dans le générateur de parités horizontales; et

ledit circuit générateur de parités de cellule redondante ($IC_2$,$IC_3$,$G_2$,$G_3$) génère une parité verticale redondante ou une parité horizontale redondante selon les données lues n'incluant pas ladite donnée interdite plus la donnée provenant de la cellule de mémoire redondante.

2. Dispositif de mémoire à semiconducteur selon la revendication 1, dans lequel ledit sélecteur de données (SEL) comprend:

une porte de sélection verticale (VSG), connectée activement entre ledit réseau de cellules de mémoire et ledit générateur de parités verticales, pour sélectionner m bits de données sur une ligne verticale sélectionnée dans ladite matrice virtuelle bidimensionnelle de contrôle de parités parmi les kxm bits d'un signal d'entrée sélectionné provenant dudit réseau de cellules de mémoire vers ledit sélecteur de données; et

une porte de sélection horizontale (HSG), connectée activement entre ledit réseau de cellules de mémoire et ledit générateur de parités horizontales, pour sélectionner k bits de données sur la ligne horizontale de ladite matrice virtuelle bidimensionnelle de contrôle de parités parmi lesdits kxm bits sélectionnés.

3. Dispositif de mémoire à semiconducteur selon la revendication 2, dans lequel ledit circuit d'interdiction comprend:

un premier circuit d'interdiction ($IC_0$)-,connecté activement entre ladite porte de sélection horizontale et ledit générateur de parités horizontales, pour interdire le passage desdits k bits de ladite porte de sélection horizontale dans ledit générateur de parités horizontales en réponse à un premier signal d'interdiction ($IS_k$) desdits signaux d'interdiction (IS), ledit premier signal d'interdiction étant engendré dans ledit circuit de commande d'interdiction quand ladite cellule de mémoire défectueuse fait l'objet d'un accès; et

un deuxième circuit d'interdiction (IC₁), connecté activement entre ladite porte de sélection verticale et ledit générateur de parités verticales, pour interdire qu'un desdits m bits passe de ladite porte de sélection verticale dans ledit générateur de parités verticales en réponse à un deuxième signal d'interdiction (IS_m) desdits signaux d'interdiction (IS),ledit deuxième signal d'interdiction étant engendré quand ladite cellule de mémoire défectueuse fait l'objet d'un accès.

4. Dispositif de mémoire à semiconducteur selon la revendication 3, dans lequel ledit circuit générateur de parités de cellule redondante comprend:

un troisième circuit d'interdiction (IC₂), connecté activement à ladite cellule de mémoire redondante, pour interdire que la donnée lue dans ladite cellule de mémoire redondante passe par ledit troisième circuit d'interdiction en réponse à un troisième signal d'interdiction (RAS_k) desdits signaux d'interdiction, ledit troisième signal d'interdiction étant engendré quand ladite cellule de mémoire défectueuse ne fait pas l'objet d'un accès;

un quatrième circuit d'interdiction (IC₃), connecté activement à ladite cellule de mémoire redondante, pour interdire que la donnée lue dans ladite cellule de mémoire redondante passe dans le quatrième signal d'interdiction (RAS_m) desdits signaux d'interdiction, ledit quatrième signal d'interdiction étant engendré quand ladite cellule de mémoire défectueuse ne fait pas l'objet d'un accès;

une première porte de parité redondante (G₂) ayant des entrées connectées activement aux sorties dudit générateur de parités horizontales et audit troisième circuit d'interdiction, pour générer ladite parité horizontale redondante; et

une deuxième porte de parité redondante (G₃) ayant des entrées connectées activement aux sorties dudit générateur de parités verticales et à ladite cellule de mémoire redondante, pour générer ladite parité verticale redondante.

5. Dispositif de mémoire à semiconducteur selon la revendication 4, dans lequel ledit comparateur comprend:

une porte de parité horizontale (G₄), ayant des entrées connectées activement à la sortie de ladite première porte de parité redondante et à ladite mémoire de mémorisation de parités, pour effectuer un traitement de parité horizontale selon ladite parité horizontale redondante et ladite parité horizontale déterminée précédemment;

une porte de parité verticale (G₅), ayant des entrées connectées activement à la sortie de ladite deuxième porte de parité redondante et à ladite mémoire de mémorisation de parités, pour effectuer un traitement de parité verticale selon ladite parité verticale redondante et ladite parité verticale déterminée précédemment; et

une porte ET (G₆) ayant des entrées connectées activement aux sorties de ladite porte de parité horizontale (G₄)et de ladite porte de parité verticale (G₅), pour fournir un signal de coïncidence quand lesdits signaux de sortie de ladite porte de parité horizontale et de ladite porte de parité verticale coïncident.

6. Dispositif de mémoire à semiconducteur selon l'une quelconque des revendications 4 et 5, dans lequel ledit circuit de commande d'interdiction comprend:

une mémoire d'adresse de colonne défectueuse (ROM) comportant une zone de mémoire pour la mémorisation de l'adresse de colonne défectueuse (A₁-A_n) de ladite cellule de mémoire défectueuse; et

un circuit générateur de signaux d'interdiction (ISG), recevant à l'état actif ladite adresse de colonne défectueuse de ladite cellule de mémoire défectueuse et un signal d'adresse de colonne externe pour spécifier une cellule de mémoire, pour fournir lesdits signaux d'interdiction quand ladite adresse de colonne défectueuse coïncide avec ladite adresse de colonne externe.

7. Dispositif de mémoire à semiconducteur selon la revendication 6, dans lequel ledit circuit générateur de signaux d'interdiction comprend:

un décodeur d'adresse horizontale (DEC₁) recevant à l'état actif une partie (A₁-A_i) de ladite adresse de colonne défectueuse de ladite mémoire d'adresse de colonne défectueuse, pour fournir k bits du signal de sortie décodé;

un décodeur d'adresse verticale (DEC₂) recevant activement une autre partie (A_{i+1}-A_n) de ladite adresse de colonne défectueuse de ladite mémoire d'adresse de colonne défectueuse, pour fournir m bits du signal de sortie décodé;

un premier comparateur (CMP₁) pour comparer ladite autre partie (A_{i+1}-A_n) de ladite adresse de colonne défectueuse à une partie correspondante (a_{i+1}-a_n) de ladite adresse de colonne externe;

un deuxième comparateur (CMP₂) pour comparer ladite partie (A₁-A_i) de ladite adresse de colonne défectueuse à une partie corres-

pondante ($a_1$-$a_i$) de ladite adresse de colonne externe;

une première porte ET ($G_{11}$) pour laisser passer lesdits k bits du signal de sortie décodé provenant dudit décodeur d'adresse horizontale par ladite première porte ET uniquement quand ledit premier comparateur engendre un premier signal de coïncidence ($IAS_k$), un desdits k bits ayant passé par ladite première porte ET étant ledit premier signal d'interdiction ($IS_k$):

une deuxième porte ET ($G_{12}$) pour laisser passer lesdits m bits du signal de sortie décodé provenant dudit décodeur d'adresse verticale par ladite deuxième porte ET uniquement quand ledit deuxième comparateur engendre un deuxième signal de coïncidence ($IAS_m$), un desdits m bits ayant passé par ladite deuxième porte ET étant ledit deuxième signal d'interdiction ($IS_m$);

une première porte-inverseur ($G_{14}$) pour inverser ledit premier signal d'interdiction de manière à fournir ledit troisième signal d'interdiction ($RAS_k$); et

une deuxième porte-inverseur ($G_{16}$) pour inverser ledit deuxième signal d'interdiction de manière à fournir ledit quatrième signal d'interdiction ($RAS_m$).

8. Dispositif de mémoire à semiconducteur selon la revendication 3, dans lequel ledit circuit générateur de parités de cellule redondante comprend:

un troisième circuit d'interdiction ($IC_4$),connecté activement à ladite mémoire de mémorisation de parités, pour interdire que les données lues dans ladite mémoire de mémorisation de parités passent par ledit troisième circuit d'interdiction en réponse à un troisième signal d'interdiction ($PIS_m$), ledit troisième signal d'interdiction étant engendré quand ladite parité horizontale déterminée précédemment comporte une erreur permanente;

un quatrième circuit d'interdiction ($IC_5$), connecté activement à ladite mémoire de mémorisation de parités, pour interdire que les données lues dans ladite mémoire de mémorisation de parités passent par ledit quatrième circuit d'interdiction en réponse à un quatrième signal d'interdiction ($PIS_k$), ledit quatrième signal d'interdiction étant engendré quand ladite parité verticale déterminée précédemment comporte un défaut permanent;

une première porte de parité ($G_2$) ayant des entrées connectées activement aux sorties dudit générateur de parités horizontales et audit troisième circuit d'interdiction, pour générer une parité horizontale;

une deuxième porte de parité ($G_3$) ayant des entrées connectées activement aux sorties dudit générateur de parités verticales et audit quatrième circuit d'interdiction, pour générer une parité verticale;

un cinquième circuit d'interdiction ($IC_2$),connecté activement à ladite cellule de mémoire redondante, pour interdire que la donnée lue dans ladite cellule de mémoire redondante passe par ledit troisième circuit d'interdiction en réponse à un cinquième signal d'interdiction ($RAS_{ka}$) desdits signaux d'interdiction, ledit cinquième signal d'interdiction étant engendré dans les deux conditions où ladite cellule de mémoire défectueuse ne fait par l'objet d'un accès et où ladite parité verticale déterminée précédemment comporte un défaut permanent;

un sixième circuit d'interdiction ($IC_3$), connecté activement à ladite cellule de mémoire redondante, pour interdire que la donnée lue dans l'adite cellule de mémoire redondante passe par ledit sixième circuit d'interdiction en réponse à un sixième signal d'interdiction ($RAS_m$) desdits signaux d'interdiction, ledit sixième signal d'interdiction étant engendré dans les deux conditions où ladite cellule de mémoire défectueuse ne fait pas l'objet d'un accès et où ladite parité horizontale déterminée précédemment comporte un défaut permanent;

une porte de parité horizontale ($G_4$), ayant des entrées connectées activement à la sortie de ladite première porte de parité et à la sortie dudit cinquième circuit d'interdiction, pour effectuer un traitement de parité horizontale;

une porte de parité verticale ($G_5$), ayant des entrées connectées activement à la sortie de ladite deuxième porte de parité et à la sortie dudit sixième circuit d'interdiction; et, pour effectuer un traitement de parité verticale;

une porte ET ($G_6$) ayant des entrées connectées activement aux sorties de ladite porte de parité horizontale ($G_4$) et à ladite porte de parité verticale ($G_5$), pour fournir un signal de coïncidence quand lesdits signaux de sortie de ladite porte de parité horizontale et de ladite porte de parité verticale coïncident.

9. Dispositif de mémoire à semiconducteur selon la revendication 8, dans lequel ledit circuit de commande d'interdiction comprend:

une mémoire d'adresse de colonne défectueuse (ROM) comportant une zone de mémoire pour mémoriser l'adresse de colonne défectueuse ($A_1$-$A_n$) de ladite cellule de mémoire défectueuse et une autre zone de mémoire (RHP,VHP) pour mémoriser des données de parité exprimant le fait que ladite parité verticale déterminée précédemment ou que ladite parité horizontale déterminée précédemment comporte ou non un défaut permanent;

un circuit générateur de signaux d'interdiction (ISG), recevant à l'état actif ladite adresse de colonne défectueuse ($a_1$-$a_n$) de ladite cellule de mémoire défectueuse, lesdites données de parité (RHP,VHP) et un signal d'adresse de colonne externe pour spécifier une cellule de mémoire, pour fournir lesdits signaux d'interdiction quand ladite adresse de colonne défectueuse coïncide avec ladite adresse de colonne externe et quand lesdites données de parité expriment que ladite parité verticale déterminée précédemment ou que ladite parité horizontale déterminée précédemment ne comporte pas de défaut permanent.

**10.** Dispositif de mémoire à semiconducteur selon la revendication 9, dans lequel ledit circuit générateur de signaux d'interdiction comprend:

un décodeur d'adresse horizontale (DEC$_1$) recevant à l'état actif une partie ($A_1$-$A_i$) de ladite adresse de colonne défectueuse de ladite mémoire d'adresse de colonne défectueuse , pour fournir k bits du signal de sortie décodé;

un décodeur d'adresse verticale (DEC$_2$) recevant à l'état actif une autre partie de ladite adresse de colonne défectueuse de ladite mémoire d'adresse de colonne défectueuse, pour fournir m bits du signal de sortie décodé;

un premier comparateur (CMP$_1$) pour comparer ladite autre partie ($A_{i+1}$-$A_n$) de ladite adresse de colonne défectueuse à une partie correspondante ($a_{i+1}$-$a_n$) de ladite adresse de colonne externe;

un deuxième comparateur (CMP$_2$) pour comparer ladite partie ($A_1$-$A_i$) de ladite adresse de colonne défectueuse à une partie correspondante ($a_1$-$a_i$) de ladite adresse de colonne externe;

une première porte ET (G$_{11}$) pour laisser passer lesdits k bits du signal de sortie décodé provenant dudit décodeur d'adresse horizontale par ladite première porte ET dans les deux conditions où ledit premier comparateur engendre un signal de coïncidence (IAS$_{ka}$) et lesdites données de parité expriment un défaut permanent dans la parité déterminée précédemment (RHP,VHP), un desdits k bits ayant passé par ladite première porte $\overline{ET}$ étant ledit premier signal d'interdiction (IS$_k$);

une deuxième porte ET (G$_{12}$) pour laisser passer lesdits m bits du signal de sortie décodé provenant dudit décodeur d'adresse verticale par ladite deuxième porte ET dans les deux conditions où ledit deuxième comparateur (CMP$_2$) engendre un signal de coïncidence et lesdites données de parité expriment un défaut permanent dans la parité déterminée précédemment (RHP,VHP), un desdits m bits ayant passé par ladite deuxième porte $\overline{ET}$ étant ledit deuxième signal d'interdiction (IS$_m$);

une première porte-inverseur (G$_{14}$) pour inverser un signal résultant de la combinaison OU logique dudit quatrième signal d'interdiction (PIS$_k$) et dudit premier signal d'interdiction de manière à fournir ledit sixième signal d'interdiction (RAS$_k$); et

une deuxième porte -inverseur (G$_{16}$) pour inverser le signal résultant de la combinaison OU logique dudit troisième signal d'interdiction (PIS$_m$) et dudit deuxième signal d'interdiction de manière à fournir ledit cinquième signal d'interdiction (RAS$_m$).

**Patentansprüche**

**1.** Halbleiterspeichervorrichtung mit:-

einem Speicherzellenarray (MCA), das eine Vielzahl von Speicherzellen enthält, die in einer Matrix angeordnet sind;

eine Fehlerkorrekturschaltung, die enthält:-

einen Datenselektor (SEL), der wirkungsmäßig mit dem Speicherzellenarray verbunden ist, um Daten zu empfangen, die aus einer Vielzahl von Speicherzellen einschließlich einer ausgewählten Speicherzelle gelesen wurden, und um selektiv einen Teil der gelesenen Daten auszugeben, welche horizontale und vertikale Paritätsprüfungsgruppen bilden, die einer Paritätsprüfung einer zweidimensionalen virtuellen Matrix entsprechen (VSG, HSG);

einen Vertikal-Paritätsgenerator (VPG) und einen Horizontal-Paritätsgenerator (HPG), die wirkungsmäßig mit dem Datenselektor verbunden sind, um eine Vertikal- bzw. eine Horizontalparität der genannten Datengruppe zu erzeugen;

einen Paritätsspeicherungsspeicher (PCA) zum Speichern einer vorher bestimmten Vertikal- und Horizontalparität;

einem Komparator (CMP), der wirkungsmäßig mit den genannten Vertikal- und Horizontal-Paritätsgeneratoren und mit dem genannten Paritätsspeicherungsspeicher verbunden ist, um deren Ausgaben zu vergleichen, um einen Fehler in den gelesenen Daten zu detektieren;

einem Datenkorrekturgatter (G$_1$) zum Korrigieren des genannten Fehlers in den gelesenen Daten, ansprechend auf eine Ausgabe des Komparators (CMP); und

einem Datenbus (DBUS), zum Transferieren gelesener Daten von dem Datenselektor (SEL) zu dem Datenkorrekturgatter (G$_1$); ge-

kennzeichnet durch:-

eine Redundanzspeicherzelle (RMC) zum Ersetzen einer defekten Speicherzelle des Speicherzellenarray (MCA);

einem Schaltungskreis (SW) zum Schalten zwischen dem Ausgang der redundanten Speicherzelle (RMC) und dem Datenbus (DBUS), welcher zwischen dem Datenbus (DBUS) und einem Eingang des Datenkorrekturgatters $(G_1)$ verbunden ist; und

ein Sperr- und Paritätsgeneratorschaltung $(IC_0\text{-}IC_3, CTL, G_2, G_3)$, mit:-

einer Sperrschaltung $(IC_0, IC_1)$, die wirkungsmäßig zwischen dem genannten Datenselektor (SEL) und den Vertikal- und Horizontal-Paritätsgeneratoren (VPG, HPG) verbunden ist;

einer Redundanzzellen-Paritätsgeneratorschaltung $(IC_2, IC_3, G_2, G_3)$, die wirkungsmäßig mit der genannten redundanten Speicherzelle und mit den Vertikal- und Horizontalparitätsgeneratoren (VPG, HPG) verbunden ist; und

einer Sperrsteuerschaltung (CTL), die wirkungsmäßig verbunden ist, um ein externes Adreßsignal zu empfangen, um eine Speicherzelle in dem Speicherzellenarray auszuwählen, und wirkungsmäßig mit dem genannten Schaltungskreis (SW), der Sperrschaltung $(IC_0, IC_1)$ und der genannten Redundanzzellen-Paritätsgeneratorschaltung $(IC_2, IC_3, G_2, G_3)$ verbunden ist;

wobei die Sperrsteuerschaltung (CTL) betreibbar ist, um, ansprechend auf eine externe Adresse, die eine defekte Speicherzelle spezifiziert, ein redundantes Schaltungssignal (RS) zu erzeugen, das dem genannten Schaltungskreis (SW) zugeführt wird, und Sperrsignale (IS), die der genannten Sperrschaltung $(IC_0, IC_1)$ zugeführt werden, und ein Steuersignal (RAS), das der genannten Redundanzzellen-Paritätsgeneratorschaltung $(IC_2, IC_3, G_2, G_3)$ zugeführt werden soll; wodurch:-

der genannte Schaltungskreis (SW) die korrekten Daten von der redundanten Speicherzelle (RMC) auswählt;

die Sperrschaltung $(IC_0, IC_1)$ einen Sperrbetrieb durchführt, bei dem Daten einschließlich Fehlerdaten, die von einer defekten Speicherzelle gelesen werden, daran gehindert werden, in den Vertikal- oder Horizontal-Paritätsgenerator zu gelangen; und

die Redundanzzellen-Paritätsgeneratorschaltung $(IC_2, IC_3, G_2, G_3)$, eine redundante Vertikal- oder Horizontalparität erzeugt, basierend auf den gelesenen Daten, die nicht die gesperrten Daten enthalten, plus den Daten von der redundanten Speicherzelle.

2. Halbleiterspeichervorrichtung nach Anspruch 1, bei dem der Datenselektor (SEL) umfaßt:-

ein Vertikal-Auswählgatter (VSG), das wirkungsmäßig zwischen dem Speicherzellenarray und dem Vertikal-Paritätsgenerator verbunden ist, um m-Bit-Daten auf einer ausgewählten vertikalen Reihe der Paritätsprüfung der zweidimensionalen virtuellen Matrix von ausgewählten kxm Bits auszuwählen, die von dem Speicherzellenarray in den Datenselektor eingegeben werden;

ein Horizontal-Auswählgatter (HSG), das wirkungsmäßig zwischen dem Speicherzellenarray und dem Horizontal-Paritätsgenerator verbunden ist, um k-Bit-Daten auf der horizontalen Reihe der Paritätsprüfung der zweidimensionalen virtuellen Matrix von den ausgewählten kxm-Bits auszuwählen.

3. Halbleiterspeichervorrichtung nach Anspruch 2, bei der die Sperrschaltung umfaßt:-

eine erste Sperrschaltung $(IC_0)$, die wirkungsmäßig zwischen dem Horizontalen-Auswählgatter und dem Horizontal-Paritätsgenerator verbunden ist, um eines der k-Bits daran zu hindern, von dem Horizontal-Auswählgatter in den Horizontal-Paritätsgenerator zu gelangen, ansprechend auf ein erstes Sperrsignal $(IS_k)$ der Sperrsignale (IS), wobei das erste Sperrsignal in der Sperrsteuerschaltung erzeugt wird, wenn die defekte Zelle adressiert wird; und

eine zweite Sperrschaltung $(IC_1)$, die wirkungsmäßig zwischen dem Vertikal-Paritätsgenerator verbunden ist, um eines der m-Bits daran zu hindern, von dem Vertikal-Auswählgatter in den Vertikal-Paritätsgenerator zu gelangen, ansprechend auf ein zweites Sperrsignal $(IS_m)$ der Sperrsignale (IS), wobei das zweite Sperrsignal erzeugt wird, wenn zu der defekten Speicherzelle zugegriffen wird.

4. Halbleiterspeichervorrichtung nach Anspruch 3, bei der die Redundanzzellen-Paritätsgeneratorschaltung umfaßt:-

eine dritte Sperrschaltung $(IC_2)$, die wirkungsgemäß mit der redundanten Speicherzelle verbunden ist, um von der redundanten Speicherzelle gelesene Daten daran zu hindern, durch die dritte Sperrschaltung hindurch zu gelangen, ansprechend auf ein drittes Sperrsignal $(RAS_k)$ der Sperrsignale, welches dritte Sperrsignal erzeugt wird, wenn zu der defekten Speicherzelle nicht zugegriffen wird;

eine vierte Sperrschaltung $(IC_3)$, die wirkungsmäßig mit der redundanten Speicherzelle verbunden ist, um von der redundanten Speicherzelle gelesene Daten daran zu hindern, durch die vierte Sperrschaltung hindurch zu gelangen, ansprechend auf ein viertes Signal (RAS $_m$) der Sperrsignale, welches vierte Sperrsignal erzeugt wird, wenn zu der defekten Speicherzelle nicht zugegriffen wird;

ein erstes redundantes Paritätsgatter ($G_2$), das Eingänge hat, die wirkungsmäßig mit den Ausgängen des Horizontal-Paritätsgenerators und der dritten Sperrschaltung verbunden sind, um die redundante horizontale Parität zu erzeugen; und

ein zweites redundantes Paritätsgatter ($G_3$), das Eingänge hat, die wirkungsmäßig mit den Ausgängen des Vertikal-Paritätsgenerators und der redundanten Speicherzelle verbunden ist, um die vertikale Parität zu erzeugen.

5. Halbleiterspeichervorrichtung nach Anspruch 4, bei der der Komparator umfaßt:-

ein Horizontal-Paritätsgatter ($G_4$), das Eingänge hat, die wirkungsmäßig mit dem Ausgang des ersten redundanten Paritätsgatters und dem Paritätsspeicherungspeicher verbunden sind, um eine horizontale Paritätsverarbeitung zu bewirken, basierend auf der redundanten Horizontal-Parität und der zuvor bestimmten Horizontal-Parität;

ein Vertikal-Paritätsgatter ($G_5$), das Eingänge hat, die wirkungsmäßig mit dem Ausgang des zweiten redundanten Paritätsgatters und mit dem Paritätsspeicherungsspeicher verbunden sind, um eine vertikale Paritätsverarbeitung durchzuführen, basierend auf der redundanten Vertikal-Parität und der zuvor bestimmten Vertikal-Parität; und

ein UND-Gatter ($G_6$), das Eingänge hat, die wirkungsmäßig mit den Ausgängen des Horizontal-Paritätsgatters ($G_4$) und dem Vertikal-Paritätsgatter ($G_5$) verbunden sind, um ein Koinzidenzsignal zu liefern, wenn die Ausgänge des Horizontal-Paritätsgatters und des Vertikal-Paritätsgatters koinzidieren.

6. Halbleiterspeichervorrichtung nach Anspruch 4 oder 5, bei der die Sperrsteuerschaltung umfaßt:-

einen Adreßspeicher (ROM) für defekte Spalten, der einen Speicherbereich zum Speichern der defekten Spaltenadresse ($A_1$-$A_n$) der defekten Speicherzelle hat; und

eine Sperrsignal-Generatorschaltung (ISG), die wirkungsmäßig die defekte Spaltenadresse der defekten Speicherzelle und ein externes Spaltenadreßsignal zum Spezifizieren einer Speicherzelle empfängt, um die Sperrsignale zu liefern, wenn die defekte Spaltenadresse mit der externen Spaltenadresse koinzidiert.

7. Halbleiterspeichervorrichtung nach Anspruch 6, bei der die Sperrsignalgeneratorschaltung umfaßt:

einen Horizontal-Adressendekoder ($DEC_1$), der wirkungsmäßig einen Teil ($A_1$-$A_i$) der defekten Spaltenadresse von dem Defektspalten-Adreßspeicher empfängt, um $\overline{k}$-Bits von dekodierter Ausgabe zu liefern;

einen Vertikaladreßdekoder ($DEC_2$), der wirkungsmäßig einen anderen Teil ($A_{i+1}$-$A_n$) der genannten Defektspaltenadresse von dem Defektspalten-Adreßspeicher empfängt, um $\overline{m}$-Bits von dekodierter Ausgabe zu liefern;

einen ersten Komparator ($CMP_1$), zum Vergleichen eines anderen Teils ($A_{i+1}$-$A_n$) der genannten Defektspaltenadresse mit einem entsprechende Teil ($a_{i+1}$-$a_n$) der genannten externen Spaltenadresse;

einen zweiten Komparator ($CMP_2$), zum Vergleichen des Teils ($A_1$-$A_i$) der Defektspaltenadresse mit einem entsprechenden Teil ($a_1$-$a_i$) der genannten externen Spaltenadresse;

ein erstes UND-Gatter ($G_{11}$), um die genannten $\overline{k}$-Bits der dekodierten Ausgabe von dem Horizontal-Adreßdekoder durch das erste UND-Gatter nur dann hindurchzugeben, wenn der erste Komparator ein erstes Koinzidenzsignal ($IAS_k$) erzeugt, wobei eines der genannten $\overline{k}$-Bits, das durch das erste UND-Gatter hindurchgelangt ist, das erste Sperrsignal ($IS_k$) ist;

ein zweites UND-Gatter ($G_{12}$), um $\overline{m}$-Bits von dekodierter Ausgabe von dem genannten Vertikal-Adreßdekoder durch das genannte zweite UND-Gatter nur dann hindurchzuführen, wenn der zweite Komparator ein zweites Koinzidenzsignal ($IAS_m$) erzeugt, wobei eines der $\overline{m}$-Bits, das durch das zweite UND-Gatter hindurchgeführt wurde, das zweite Sperrsignal ($IS_m$) ist;

ein erstes Invertergatter ($G_{14}$), zum Invertieren des genannten ersten Sperrsignals, um so das dritte Sperrsignal ($RAS_k$) zu liefern; und

ein zweites Invertergatter ($G_{16}$), um das zweite Sperrsignal zu invertieren, um so das vierte Sperrsignal ($RAS_m$) zu liefern.

8. Halbleiterspeichervorrichtung nach Anspruch 3, bei der die Redundanzzellen-Paritätsgeneratorschaltung umfaßt:-

eine dritte Sperrschaltung ($IC_4$), die wirkungsmäßig mit dem Paritätspeicherungsspeicher verbunden ist, um zu verhindern, daß Daten, die von dem Paritätsspeicherungsspeicher gelesen wurden, zu der dritten Sperrschaltung hindurchgelangen, ansprechend auf eine drittes Sperrsignal ($PIS_m$), welches dritte Sperrsignal erzeugt wird, wenn die zuvor bestimmte horizontale Parität einen Hart-Fehler hat;

eine vierte Sperrschaltung (IC$_5$), die wirkungsmäßig mit dem genannten Paritätsspeicherungsspeicher verbunden ist, um Daten, die von dem genannten Paritätsspeicherungsspeicher gelesen wurden, daran zu hindern, daß sie durch die vierte Sperrschaltung hindurchgelangen, ansprechend auf ein viertes Sperrsignal (PIS$_k$), welches vierte Sperrsignal erzeugt wird, wenn die zuvor bestimmte vertikale Parität einen Hart-Defekt hat;

ein erstes Paritätsgatter (G$_2$), das Eingänge hat, die wirkungsmäßig mit den Ausgängen des genannten Horizontal-Paritätsgenerators und der dritten Sperrschaltung verbunden sind, um eine horizontale Parität zu erzeugen;

ein zweites Paritätsgatter (G$_3$), das Eingänge hat, die wirkungsmäßig mit den Ausgängen des genannten Vertikal-Paritätsgenerators und der vierten Sperrschaltung verbunden sind, um eine vertikale Parität zu erzeugen;

eine fünfte Sperrschaltung (IC$_2$), die wirkungsmäßig mit der Redundanzspeicherzelle verbunden ist, um Daten, die von der Redundanzspeicherzelle gelesen werden, daran zu hindern, durch die dritte Sperrschaltung hindurch zu gelangen, ansprechend auf ein fünftes Sperrsignal (RAS$_{ka}$) der Sperrsignale, welches fünfte Sperrsignal in beiden Zuständen erzeugt wird, in denen zu der defekten Speicherzelle nicht zugegriffen wird und die zuvor bestimmte vertikale Parität einen Hart-Defekt hat;

eine sechste Sperrschaltung (IC$_3$), die wirkungsmäßig mit der genannten Redundanzspeicherzelle verbunden ist, um Daten, die von der Redundanzspeicherzelle gelesen wurden, daran zu hindern, durch die sechste Sperrschaltung hindurch zu gelangen, ansprechend auf ein sechstes Sperrsignal (RAS$_m$) der Sperrsignale, welches sechste Sperrsignal in beiden Zuständen erzeugt wurde, bei denen zu der defekten Speicherzelle nicht zugegriffen wurde und die zuvor bestimmte horizontale Parität einen Hart-Defekt hat;

ein Horizontal-Paritätsgatter (G$_4$), das Eingänge hat, die wirkungsmäßig mit dem Ausgang des genannten ersten Paritätsgatters und mit dem Ausgang der fünften Sperrschaltung verbunden sind, um eine Horizontal-Paritätsverarbeitung zu bewirken;

ein Vertikal-Paritätsgatter (G$_5$), das Eingänge hat, die wirkungsmäßig mit dem Ausgang des zweiten Paritätsgatters und dem Ausgang der sechsten Sperrschaltung verbunden sind; und, zum Bewirken einer Vertikal-Paritätsverarbeitung;

ein UND-Gatter (G$_6$), das Eingänge hat, die wirkungsmäßig mit den Ausgängen des

Horizontal-Paritätsgatters (G$_4$) und des Vertikal-Paritätsgatters (G$_5$) verbunden sind, um ein Koinzidenzsignal zu liefern, wenn die genannten Ausgänge des genannten Horizontal-Paritätsgatters und des Vertikal-Paritätsgatters koinzidieren.

**9.** Halbleiterspeichervorrichtung nach Anspruch 8, bei der die Sperrsteuerschaltung umfaßt:

einen Adreßspeicher (ROM) für eine defekte Spalte, der einen Speicherbereich zum Speichern der Defektspaltenadresse (A$_1$-A$_n$) der defekten Speicherzelle und einen anderen Speicherbereich (RHP, VHP) zum Speichern der Paritätsdaten hat, die ausdrücken, ob die zuvor bestimmte vertikale oder horizontale Parität einen Hart-Defekt hat oder nicht;

eine Sperrsignal-Generatorschaltung (ISG), die wirkungsmäßig die Defektspaltenadresse (a$_1$-a$_n$) der genannten defekten Speicherzelle, die Paritätsdaten (RHP, VHP) und ein externes Spaltenadreßsignal zum Spezifizieren einer Speicherzelle empfängt, um die genannten Sperrsignale zu liefern, wenn die Defektspaltenadresse mit der externen Spaltenadresse konzidiert und wenn die Paritätsdaten ausdrükken, daß die zuvor bestimmte vertikale oder horizontale Parität keinen Hart-Defekt hat.

**10.** Halbleiterspeichervorrichtung nach Anspruch 9, bei der die Sperrsignal-Generatorschaltung umfaßt:

einen Horizontal-Adreßdekoder (DEC$_1$), der wirkungsmäßig einen Teil (A$_1$-A$_i$) der Defektspaltenadresse von dem Defektspaltenadreßspeicher empfängt, um k-Bits von dekodierter Ausgabe zu liefern;

einen Vertikal-Adreßdekoder (DEC$_2$), der wirkungsmäßig einen anderen Teil der genannten Defektspaltenadresse von dem Defektspalten-Adreßspeicher empfängt, um m-Bits von dekodierter Ausgabe zu liefern;

einen ersten Komparator (CMP$_1$) zum Vergleichen des anderen Teils (A$_{i+1}$-A$_n$) der Defektspaltenadresse mit einem entsprechenden Teil (a$_{i+1}$-a$_n$) der genannten externen Spaltenadresse;

einen zweiten Komparator (CMP$_2$) zum Vergleichen des genannten Teils (A$_1$-A$_i$) der Defektspaltenadresse mit einem entsprechenden Teil (a$_1$-a$_i$) der externen Spaltenadresse;

ein erstes UND-Gatter (G$_{11}$) zum Hindurchführen der genannten k-Bits von dekodierter Ausgabe von dem Horizontal-Adressendekoder durch das genannte erste UND-Gatter in beiden Zuständen, wo der erste Komparator ein Koinzidenzsignal (IAS$_{ka}$) erzeugt und die Paritätsdaten einen Hart-Defekt in der zuvor bestimmten Parität (RHP, VHP) ausdrücken, wobei eines der k-Bits, das durch das erste UND-Gatter hindurchgeführt wurde, das erste Sperrsignal ($IS_k$) ist;

ein zweites UND-Gatter ($G_{12}$), zum Hindurchführen der m-Bits von dekodierter Ausgabe von dem Vertikal-Adreßdekoder durch das zweite UND-Gatter, in beiden Zuständen, wo der zweite Komparator ($COMP_2$) ein Koinzidenzsignal erzeugt und die Paritätsdaten einen Hart-Defekt in der zuvor bestimmten Parität (RHP, VHP) ausdrücken, wobei eines der m-Bits, das durch das zweite UND-Gatter hindurchgelangt ist, das zweite Sperrsignal ($IS_m$) bildet;

ein erste Inverter-Gatter ($G_{14}$) zum Invertieren eines logischen ODER der vierten Sperrsignals ($PIS_k$) und des ersten Sperrsignals, um so das sechste Sperrsignal ($RAS_k$) zu liefern; und

ein zweites Invertergatter ($G_{16}$) zum Invertieren eines logischen ODER des dritten Sperrsignals ($PIS_m$) und des zweiten Sperrsignals, um so das fünfte Sperrsignal ($RAS_m$) zu liefern.

# Fig. 1

# Fig. 2

$\underline{SEL}$ (k)

VSG

| | HPC$_1$ | HPC$_2$ | | HPC$_j$ | | HPC$_m$ | |
|---|---|---|---|---|---|---|---|
| VPC$_1$ | MC$_1$ (1,1) | MC$_{k+1}$ (1,2) | --- | MC$_{(j-1)k+1}$ (1,j) | --- | MC$_{(m-1)k+1}$ (1,m) | |
| VPC$_2$ | MC$_2$ (2,1) | MC$_{k+2}$ (2,2) | --- | MC$_{(j-1)k+2}$ (2,j) | --- | MC$_{(m-1)k+2}$ (2,m) | |
| | --- | --- | --- | --- | --- | --- | |
| VPC$_i$ | MC$_i$ (i,1) | MC$_{k+i}$ (i,2) | --- | MC$_{(j-1)k+i}$ (i,j) | --- | MC$_{(m-1)k+i}$ (i,m) | |
| | --- | --- | | --- | | --- | |
| VPC$_k$ | MC$_k$ (k,1) | MC$_{2k}$ (k,2) | --- | MC$_j$ (k,j) | --- | MC$_{mk}$ (k,m) | |

HSG (m)

# Fig. 3

# Fig. 4

## I C

EP 0 172 734 B1

# Fig. 5

25

# Fig. 6

# Fig. 7

CTLa